# EUROPEAN PATENT SPECIFICATION

(11) **EP 1 670 138 B1**
(45) Date of publication and mention of the grant of the patent: **27.05.2009**
(21) Application number: 04771869.7
(22) Date of filing: 19.08.2004
(51) Int. Cl.: H03H 9/00

(54) **SURFACE ACOUSTIC WAVE FILTER AND COMMUNICATION UNIT**
AKUSTISCHER WELLENFILTER UND KOMMUNIKATIONSEINHEIT
FILTRE D'ONDE ACOUSTIQUE DE SURFACE ET UNITE DE COMMUNICATION

(30) Priority: 25.09.2003 JP 2003332932
(43) Date of publication of application: 14.06.2006
(73) Proprietor: MURATA MANUFACTURING CO., LTD., Nagaokakyo-shi, Kyoto 617-8555 (JP)
(72) Inventor: TAKAMINE, Yuichi, c/o Murata Manufacturing Co. Ltd, Nagaokakyo-shi, Kyoto 617-8555 (JP)
(74) Representative: Thévenet, Jean-Bruno
(86) International application number: PCT/JP2004/011908
(87) International publication number: WO 2005/031971

(56) References cited:
- EP-A- 1 249 934
- EP-A- 1 263 137
- EP-A- 1 280 274
- EP-A- 1 330 027
- EP-A- 1 341 304
- EP-A2- 1 330 027
- JP-A- 11 097 966
- JP-A- 2003 046 369
- PATENT ABSTRACTS OF JAPAN vol. 1999, no. 09, 30 July 1999 (1999-07-30) & JP 11 097966 A (TDK CORP), 9 April 1999 (1999-04-09)

## Description

### BACKGROUND OF THE INVENTION

### 1. Field of the Invention

The present invention relates to a surface acoustic wave filter which has a balance-unbalance conversion function and in which at least one of an amplitude balance characteristic and a phase balance characteristic is improved, and the present invention also relates to a communication apparatus including such a surface acoustic wave filter.

### 2. Description of the Related Art

In the recent years, there has been remarkable technological progress in reducing the size and weight of communication apparatuses such as cellular phones. To achieve this reduction in size, not only have the number and size of constituent components been reduced, but also components in which a plurality of functions are combined have been developed. Accordingly, surface acoustic wave filters for use in an RF stage of a communication apparatus and having a balance-unbalance conversion function, which is a so-called balun function, have also been actively studied in recent years. They have been use primarily in GSM (Global System for Mobile Communications). Also, some patent applications concerning surface acoustic wave filters provided with balance-unbalance conversion functions of the above-described type have been filed.

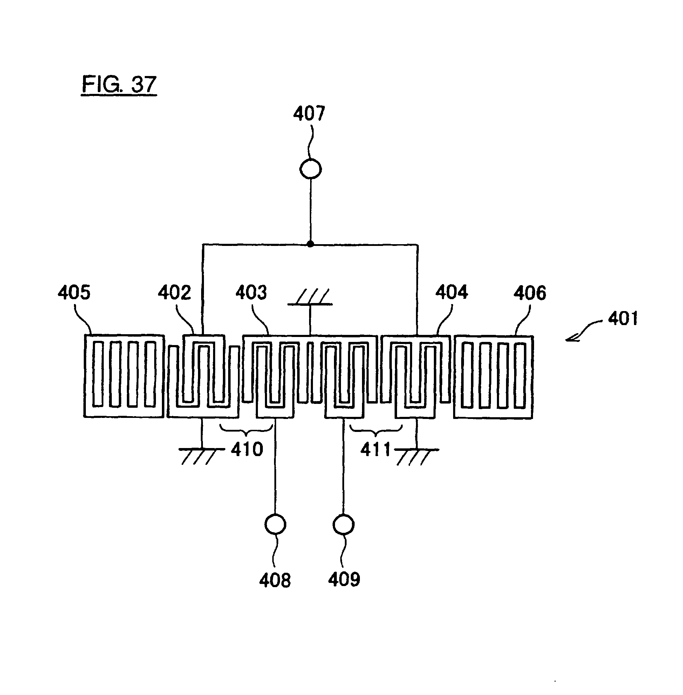

Fig. 37 shows a surface acoustic wave filter disclosed in Patent Document 1 (Japanese Unexamined Patent Application Publication No. 11-097966) which has a balance-unbalance conversion function having an impedance of 50 Ω at an unbalanced signal terminal and an impedance of 200 Q at a balanced signal terminal. As shown in Fig. 37, in a longitudinally-coupled-resonator surface acoustic wave filter 401 having three interdigital transducers (hereinafter referred to as IDTs), one comb electrode of an IDT 403 located in the center is substantially symmetrically divided into two portions in a surface-acoustic-wave propagation direction. The divided portions are connected to balanced signal terminals 408 and 409, respectively, and left and right IDTs 402 and 404, whose polarities are inverted, are connected to an unbalanced signal terminal 407.

This allows the surface acoustic wave filter to have a balance-unbalance conversion function, and the impedance at the balanced signal terminal is set to be approximately four times the impedance at the unbalanced signal terminal.

In addition, Patent Document 2 (Japanese Unexamined Patent Application Publication No. 2003-46369) discloses that an IDT of a float balance type has asymmetry with respect to the central portion, in a surface-acoustic-wave propagation direction in the IDT, which is an imaginary central axis perpendicular to the surface-acoustic-wave propagation.

Specifically, Patent Document 2 describes 1) the distance between adjacent comb electrodes, 2) the ratio (hereinafter referred to as the duty ratio) of an electrode finger width relative to the pitch of an IDT, 3) an IDT pitch, and the formation of narrow pitch electrode fingers so as to have asymmetric pitches.

Regarding a surface acoustic wave filter having a balance-unbalance conversion function, in transmission characteristics in passbands in conjunction with each of an unbalanced signal terminal and a balanced signal terminal, amplitude characteristics must be equal and phases must be inverted by 180 degrees. These are called the degree of amplitude balance and the degree of phase balance.

The degree of amplitude balance and the degree of phase balance are defined as the degree of amplitude balance = |A|, A = |20log(S21)|-|20log(S31)|, the degree of phase balance =
|B-180|, and B = |∠S21-∠S31|, assuming that a filter device having the above balance-unbalance conversion function is a three-port device, and that, for example, an unbalanced input terminal is port 1, and balanced output terminals are port 2 and port 3. Ideally, in the passband of the filter, the degree of amplitude balance is 0 dB and the degree of phase balance is 0 degrees.

However, the degrees of balance of the configuration shown in Fig. 37 are bad. The reason for this is that, the polarities of electrode fingers adjacent to the IDT 403 differ between the IDT 402 and the IDT 404 (410 and 411 in Fig. 37), which causes differences in parasitic capacitance and bridging capacitance which are input to and occur in the balanced signal terminals 408 and 409. In addition, the excitation of surface acoustic waves which is caused by interaction with electrode fingers of adjacent IDTs differs.

### SUMMARY OF THE INVENTION

To overcome the problems described above, preferred embodiments of the present invention provide a surface acoustic wave filter which has a balance-unbalance conversion function having an improved degree of balance and which has a difference between the impedance of a balanced signal terminal and the impedance of an unbalanced signal terminal, for example, one is approximately four times the other, and a communication apparatus including such a novel filter.

A surface acoustic wave filter according to a preferred embodiment of the present invention includes
a piezoelectric substrate;
an unbalanced signal terminal;
first and second balanced signal terminals; and
a longitudinally-coupled-resonator surface acoustic wave filter portion provided on the piezoelectric substrate and connected between the unbalanced signal terminal and the first and second balanced signal terminals;
wherein
the longitudinally-coupled-resonator surface acoustic wave filter portion includes an odd number of at least three interdigital transducers arranged such that a plurality of comb electrodes having a plurality of electrode fingers are interdigitated, the interdigital transducers being disposed along a surface-acoustic-wave propagation direction, and first and second reflectors disposed along the surface-acoustic-wave propagation direction so that the at least three interdigital transducers are located between the first and second reflectors;
the odd number of at least three interdigital transducers include a central interdigital transducer arranged in the approximate center, and first and second interdigital transducers disposed at two sides of the central interdigital transducer, the outermost electrode fingers of the central interdigital transducer being adjacent to the first and second interdigital transducers, the polarity of the first interdigital transducer being inverted relative to the polarity of the second interdigital transducer;
one of the opposing comb electrodes of the central interdigital transducer (504) is bisected and so comprises first and second bisected comb electrodes;
the first and second bisected comb electrodes are respectively arranged toward the first and second interdigital transducers and are respectively connected to said first and second balanced signal terminals; and
the first and second interdigital transducers which are adjacent to the central interdigital transducer are electrically connected to said unbalanced signal terminal;
**characterized in that**
an electrode finger of the first interdigital transducer which is adjacent to the central interdigital transducer is a ground electrode, and an electrode finger of the second interdigital transducer which is adjacent to the central interdigital transducer is a signal electrode;
and either:
the polarities of two outermost electrode fingers of the central interdigital transducer are substantially identical to that of the ground electrode or a float electrode, and the electrode finger pitch of at least a portion of the first interdigital transducer is greater than the electrode finger pitch of the second interdigital transducer; or
the polarities of two outermost electrode fingers of the central interdigital transducer are substantially identical to that of the signal electrode, and the electrode finger pitch of at least a portion of the second interdigital transducer is greater than the electrode finger pitch of the first interdigital transducer.

In a preferred embodiment of the surface acoustic wave filter of the present invention, the electrode finger pitch of at least a portion of the first bisected comb electrode between the first and second bisected comb electrodes, which is closer to the first interdigital transducer, is greater than the electrode finger pitch of the second bisected comb electrode.

In another preferred embodiment of the surface acoustic wave filter of the present invention, an adjacent-electrode-finger center-to-center distance between the first interdigital transducer and the central interdigital transducer is greater than an adjacent-electrode-finger center-to-center distance between the second interdigital transducer and the central interdigital transducer.

In another preferred embodiment of the surface acoustic wave filter of the present invention, the polarities of two outermost electrode fingers of the central interdigital transducer are identical to that of a ground electrode or a float electrode, and an electrode-finger center-to-center distance between the first interdigital transducer and the first reflector adjacent to the first interdigital transducer is greater than an electrode-finger center-to-center distance between the second interdigital transducer and the second reflector adjacent to the second interdigital transducer.

In another preferred embodiment of the surface acoustic wave filter of the present invention, the polarities of two outermost electrode fingers of the central interdigital transducer are identical to that of a signal electrode, and an electrode-finger center-to-center distance between the second interdigital transducer and the second reflector adjacent to the second interdigital transducer is greater than an electrode-finger center-to-center distance between the first interdigital transducer and the first reflector adjacent to the first interdigital transducer.

In another preferred embodiment of the surface acoustic wave filter of the present invention, the duty ratio of the electrode fingers in at.least a portion of the first interdigital transducer is greater than the duty ratio of the electrode fingers of the second interdigital transducer.

In another preferred embodiment of the surface acoustic wave filter of the present invention, the polarities of two outermost electrode fingers of the central interdigital transducer are identical to that of a ground electrode or a float electrode, and the duty ratio of the electrode fingers of the first bisected comb electrode is greater than the duty ratio of the electrode fingers of the second bisected comb electrode.

In another preferred embodiment of the surface acoustic wave filter of the present invention, two outermost electrode fingers of the central interdigital transducer are signal electrodes, and the duty ratio of electrode fingers of the second bisected comb electrode is greater than the duty ratio of electrode fingers of the first bisected comb electrode.

In another preferred embodiment of the surface acoustic wave filter of the present invention, the odd number of at least three interdigital transducers includes, in portions in which two interdigital transducers are adjacent to each other, narrow pitch electrode finger portions having relatively smaller electrode finger pitches as compared to surrounding electrode finger portions, and the electrode finger pitch of one narrow pitch electrode finger portion in a portion in which the first interdigital transducer and the first bisected comb electrode are adjacent to each other is greater than the electrode finger pitch of one narrow pitch electrode finger portion in a portion in which the second interdigital transducer and the second bisected comb electrode are adjacent to each other.

In still another preferred embodiment of the surface acoustic wave filter of the present invention, the surface acoustic wave filter further includes a second longitudinally-coupled-resonator surface acoustic wave filter portion cascade-connected to the longitudinally-coupled-resonator surface acoustic wave filter portion.

A communication apparatus according to yet another preferred embodiment of the present invention includes the surface acoustic wave filter according to the preferred embodiments of the present invention described above.

According to the surface acoustic wave filter of the various preferred embodiments of the present invention, as described above, in a surface acoustic wave device which may include surface acoustic wave resonators and which includes an odd number of at least three IDTs disposed on a piezoelectric substrate along a surface-acoustic-wave propagation direction, and first and second reflectors which are arranged such that the at least three IDTs are disposed therebetween, and which includes first and second bisected comb electrodes arranged such that, among the odd number of at least three IDTs, one comb electrode of the central IDT is substantially symmetrically bisected along the surface-acoustic-wave propagation direction, whereby a balance-unbalance conversion function is provided, the outermost electrode finger of a first IDT, adjacent to the outermost electrode finger located at one end of the central IDT, is a ground electrode whereas the outermost electrode finger of a second IDT, adjacent to the outermost electrode finger located at the other end of the central IDT, is a signal electrode and the electrode finger pitch of the first IDTis set to be different from the electrode finger pitch of the second IDT, wherein either: the polarities of the outermost electrode fingers of the central IDT are substantially identical to that of one of the ground electrode and a float electrode and the electrode finger pitch of at least a portion of the first IDT is set higher than the electrode finger pitch of the second IDT, or the polarities of the outermost electrode fingers of the central IDT are substantially identical to that of the signal electrode and the electrode finger pitch of at least a portion of the second IDT is set higher than the electrode finger pitch of the first IDT.

In the above-described configuration, by providing the first and second bisected comb electrodes, a surface acoustic wave filter is provided which has a balance-unbalance conversion function and in which the impedance of the balanced signal terminal differs from the impedance of the unbalanced signal terminal, for example, approximately four times the impedance of the unbalanced signal terminal.

In addition, according to the above-described configuration, by setting the combination of the polarities of the electrode fingers of the IDTs and the electrode finger pitches of the IDTs as described above, the degrees of balance, such as the degree of amplitude balance and the degree of phase balance, are improved.

Other features, elements, steps, characteristics and advantages of the present invention will become more apparent from the following detailed description of preferred embodiments with reference to the attached drawings.

### BRIEF DESCRIPTION OF THE DRAWINGS

Fig. 1 is a schematic circuit diagram showing an electrode configuration in a first preferred embodiment according to a surface acoustic wave filter of the present invention.
Fig. 2 is a main portion illustration of an electrode finger pitch in the electrode configuration of Fig. 1.
Fig. 3 is a plan view showing back surface terminals of a package of the first preferred embodiment of the present invention.
Fig. 4 is a schematic sectional view showing the device structure of the first preferred embodiment of the present invention.
Fig. 5 is a graph showing results of degrees of phase balance between the first preferred embodiment and a first example of the related art.
Fig. 6 is a graph showing results of degrees of phase balance between the first example of the related art and a first comparative example.
Fig. 7 is a schematic circuit diagram showing the electrode configuration of a second preferred embodiment according to the surface acoustic wave filter of the present invention.
Fig. 8 is a graph showing results of amplitude balance between the second preferred embodiment and a second example of the related art.
Fig. 9 is a schematic circuit diagram showing an electrode configuration concerning a surface acoustic wave filter of the example of the related art.
Fig. 10 is a plan view showing back surface terminals of another package in the first preferred embodiment and a second preferred embodiment of the present invention.
Fig. 11 is a schematic sectional view showing another device structure in each of the first and second preferred embodiments of the present invention.
Fig. 12 is a schematic sectional view showing still another device structure in each of the first and second preferred embodiments of the present invention.
Fig. 13 is a schematic circuit diagram of a modification of each of the first and second preferred embodiments of the present invention.
Fig. 14 is a graph showing the results of the degree of phase balance in a first additional arrangement and a first example of the related art according to a surface acoustic wave filter of the present invention.
Fig. 15 is a graph showing the results of the degree of amplitude balance in a first additional arrangement and a first example of the related art according to a surface acoustic wave filter of the present invention.
Fig. 16 is a schematic illustration of an electrode-finger center-to-center distance of outermost electrode fingers between two IDTs in the above surface acoustic wave filter.
Fig. 17 is a graph showing the results of the degree of phase balance in a second additional arrangement and the first example of the related art according to the surface acoustic wave filter of the present invention.
Fig. 18 is a graph showing the results of the degree of amplitude balance in a modification of the second additional arrangement and a second example of the related art.
Fig. 19 is a schematic illustration of an electrode-finger center-to-center distance between outermost electrode fingers of an IDT and a reflector in the above surface acoustic wave filter.
Fig. 20 is a graph showing the results of the degree of phase balance in a third additional arrangement and the first example of the related art according to the surface acoustic wave filter of the present invention.
Fig. 21 is a graph showing the results of the degree of amplitude balance in a modification of the third additional arrangement and a second example of the related art according to a surface acoustic wave filter of the present invention.
Fig. 22 is a schematic illustration of a duty ratio in the surface acoustic wave filter of Fig. 21.
Fig. 23 is a graph showing the results of the degree of phase balance in a fourth additional arrangement and the first example of the related art according to the surface acoustic wave filter of the present invention.
Fig. 24 is a graph showing the results of the degree of amplitude balance in a modification of the fourth additional arrangement and the second example of the related art.
Fig. 25 is a graph showing the results of the degree of phase balance in a fifth additional arrangement and the first example of the related art according to the surface acoustic wave filter of the present invention.
Fig. 26 is a graph showing the results of the degree of amplitude balance in a modification of the fifth additional arrangement and the second example of the related art.
Fig. 27 is a graph showing the results of the degree of phase balance in an sixth additional arrangement and the first example of the related art according to the surface acoustic wave filter of the present invention.
Fig. 28 is a graph showing the results of the degree of amplitude balance in a modification of the sixth additional arrangement and the second example of the related art.
Fig. 29 is a schematic circuit diagram showing an electrode configuration of a seventh additional arrangement according to the surface acoustic wave filter of the present invention.
Fig. 30 is a graph showing the results of the degree of phase balance in the seventh additional arrangement and the third example of the related art.
Fig. 31 is a schematic circuit diagram showing another electrode configuration in the seventh additional arrangement of the present invention.
Fig. 32 is a schematic circuit diagram showing still another electrode configuration in the seventh additional arrangement of the present invention.
Fig. 33 is a graph showing the results of the degree of phase balance in a eighth additional arrangement and the third example of the related art according to the surface acoustic wave filter of the present invention.
Fig. 34 is a graph showing the results of the degree of phase balance in an ninth additional arrangement and the third example of the related art according to the surface acoustic wave filter of the present invention.
Fig. 35 is a graph showing the results of the degree of phase balance in a tenth additional arrangement and the third example of the related art according to the surface acoustic wave filter of the present invention.
Fig. 36 is a schematic plan view showing an electrode configuration of a surface acoustic wave filter of the present invention in which a second longitudinally-coupled-resonator surface acoustic wave filter portion is cascade-connected to the longitudinally-coupled-resonator surface acoustic wave filter portion shown in Fig. 1.
Fig. 37 is a schematic circuit diagram showing an electrode configuration of a surface acoustic wave filter of the related art.

### DETAILED DESCRIPTION OF PREFERRED EMBODIMENTS

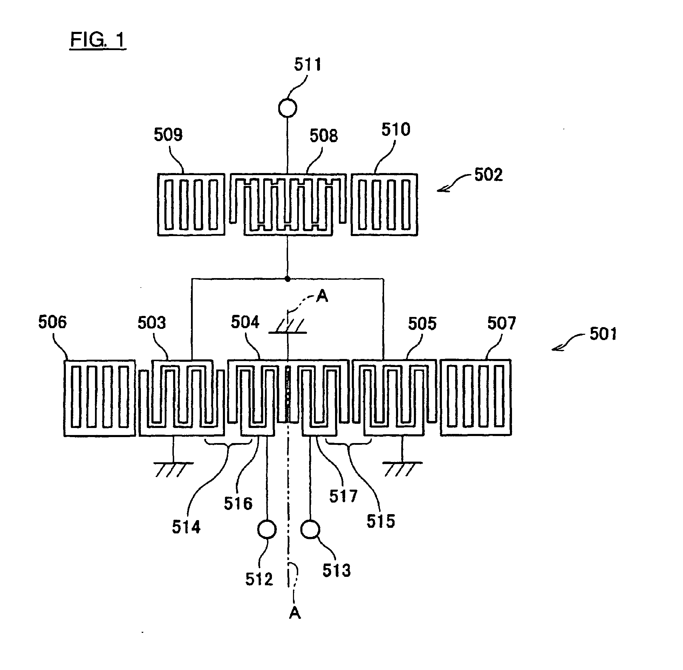

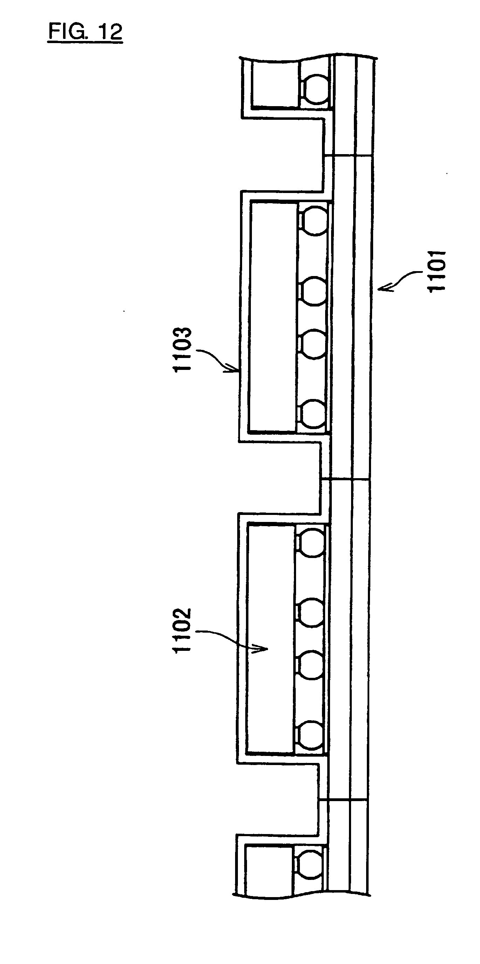

Preferred embodiments of the present invention will be described below with reference to Figs. 1 to 35.

### First Preferred Embodiment

The configuration of a first preferred embodiment of a surface acoustic wave filter of the present invention is described with reference to Figs. 1 to 4. In the following preferred embodiment, a DCS receiving filter is described. First, the electrode configuration of the first preferred embodiment will be described with reference to Fig. 1.

In the first preferred embodiment, a longitudinally-coupled-resonator surface acoustic wave filter portion 501 and a surface acoustic wave resonator 502 connected in series to the longitudinally-coupled-resonator surface acoustic wave filter portion 501 are defined by aluminum (A1) electrodes disposed on a piezoelectric substrate (not shown) preferably made of 40±5°-Y-cut-X-propagation LiTaO₃.

In the longitudinally-coupled-resonator surface acoustic wave filter portion 501, first and second IDTs 503 and 505 are arranged such that an IDT (central IDT) 504 is provided therebetween along a direction in accordance with a surface-acoustic-wave propagation direction. In addition, on both ends of the area in which the IDTs 503 to 505 are disposed, reflectors 506 and 507 are provided.

Each IDT includes two comb electrodes having base portions (bus bars), and a plurality of parallel electrode fingers extending in a direction that is substantially perpendicular to base portion. The comb electrodes have electrode fingers whose side portions oppose one another in an interdigitated arrangement.

Accordingly, in the IDT, when a potential difference is generated based on an input electrical signal in the two comb electrodes through each base portion (bus bar), surface acoustic waves are generated in the portion of the surface of the piezoelectric substrate, the surface acoustic waves are bidirectionally propagated in the widthwise direction (the direction that is substantially perpendicular to the longitudinal direction of each electrode finger) of each electrode finger.

In addition, when no electrical signal is input to the IDT, the potential difference generated on the surface of the piezoelectric substrate based on the propagated surface acoustic waves is detected by each electrode finger, and is converted into an output electrical signal before being output.

In the IDT of this type, by setting each of the length and width of each electrode finger, the distance between adjacent electrode fingers, an interdigital width defined by the length of the opposing portions of adjacent electrode fingers, a signal conversion characteristic and passband can be set.

Each reflector includes a pair of base portions (bus bars) arranged substantially in parallel, and a plurality of parallel electrode fingers which extend from between and are connected to each base portion. The electrode fingers of the reflectors are arranged substantially in parallel to the electrode fingers of the IDTs and along the surface-acoustic-wave propagation direction, whereby propagated surface acoustic waves can be reflected in the propagation direction.

As seen in Fig. 1, in a portion in which the IDT 503 and the IDT 504 are adjacent to each other, and in a portion in which the IDT 504 and the IDT 505 are adjacent to each other, the pitch of several electrode fingers is set to be less than that of the other IDT portions (the portions denoted by reference numerals 514 and 515 in Fig. 1).

The IDT 504 includes first and second bisected comb electrodes 516 and 517 at adjacent locations in a direction in which one comb electrode is disposed along the surface-acoustic-wave propagation direction. The first bisected comb electrode 516 is connected to a first balanced signal terminal 512. The second bisected comb electrode 517 is connected to a second balanced signal terminal 513.

The surface acoustic wave resonator 502 includes reflectors 509 and 510 arranged such that an IDT 508 is provided therebetween. One comb electrode of the IDT 508 is connected to the unbalanced signal terminal 511 and the other comb electrode of the IDT 508 is connected to the IDTs 503 and 505, whereby the surface acoustic wave resonator 502 is connected in series to the longitudinally-coupled-resonator surface acoustic wave filter portion 501.

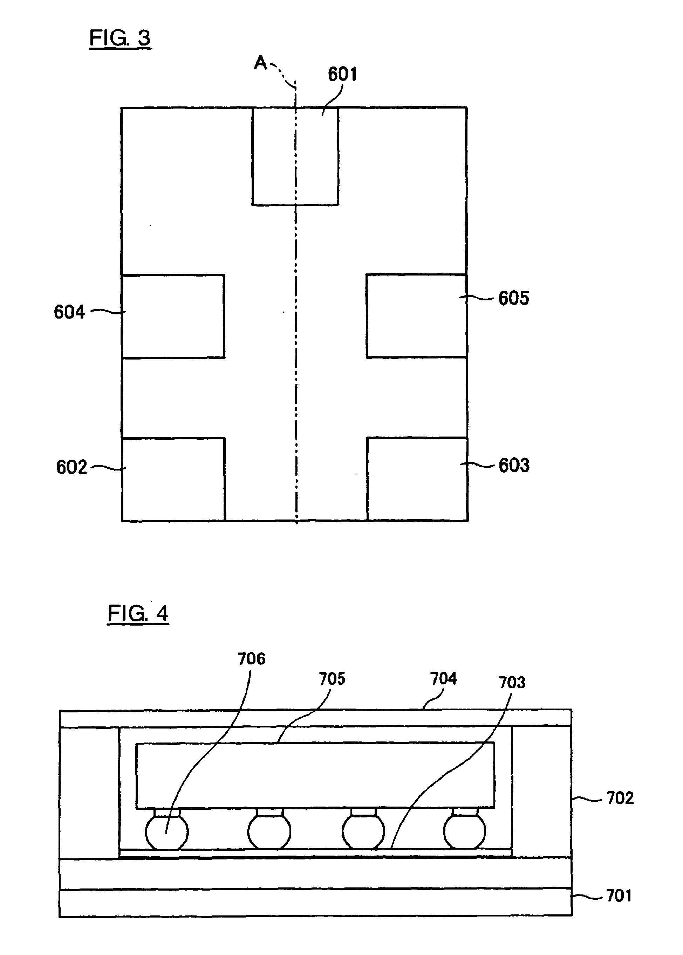

Fig. 3 shows back surface terminals of the package in the first preferred embodiment (in a perspective view from the top of the device). A back surface terminal 601 is an unbalanced signal terminal connected to the surface acoustic wave resonator 502, back surface terminals 602 and 603 are balanced signal terminals connected to the divided comb electrodes 516 and 517, and back surface terminals 604 and 605 are ground terminals.

The surface acoustic wave filter according to the first preferred embodiment is produced, as shown in Fig. 4, by a face-down mounting technique in which bumps 706 establish conduction between an electrode surface of a piezoelectric substrate 705 and a die-attach surface 703 of a package. The package has a bottom plate 701, side wall portions 702, and a cap 704.

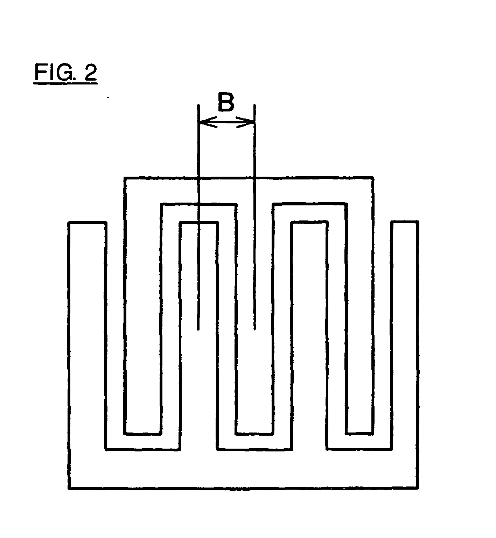

The first preferred embodiment is **characterized in that** the electrode finger pitch (the distance indicated by reference alphabet B in Fig. 2) of the IDTs 503 and 505 differ. In this case, the electrode finger pitch of the IDT 503 is preferably set to be about 0.001 µm greater than that of the IDT 505, for example.

In addition, electrode fingers of the IDT 504 which are adjacent to the IDTs 503 and 505 are neutral electrodes (either float electrodes or ground electrodes may be used), an electrode finger of the IDT 503 adjacent to the IDT 504 is a ground electrode, and an electrode finger of the IDT 505 adjacent to the IDT 504 is a signal electrode.

In addition, in the first preferred embodiment, except that the pitches of the IDTs 503 and 503 differ, the layout (the layout of each electrode) on the piezoelectric substrate and the entire package (for example, the layout of each back surface terminal, see Fig. 3) are axially symmetrical with respect to an imaginary central axis A that vertically extends in the surface-acoustic-wave propagation direction around the middle between the bisected first comb electrode 516 and second comb electrode 517 of the IDT 514 shown in Fig. 1.

This prevents input (generation) of other unbalanced components other than that arising because the polarity of the electrode finger adjacent to the IDT 504 differs between the IDTs 503 and 505.

When a wavelength determined by the pitch of electrode fingers whose pitch is not reduced is represented by λI, a detailed design of the longitudinally-coupled-resonator surface acoustic wave filter portion 501 is as follows:
interdigital width: 69.7λI
the numbers of electrode fingers of IDTs (in the order of reference numerals 503, 504, and 505): 17(3)/(3)26(3)/(3)17 (the parenthesized portions represent the numbers of electrode fingers having a reduced pitch and the values outside the parenthesized portions represent the numbers of electrode fingers)
the number of electrode fingers of reflectors: 200
duty ratio: 0.72 (both in IDT and reflector)
electrode film thickness: 0.095λI

A detailed design of the surface acoustic wave resonator 502 is as follows:
interdigital width: 42.7λI
the number of IDTs: 145
the number of reflectors: 100
duty ratio: 0.72
electrode film thickness: 0.097λI

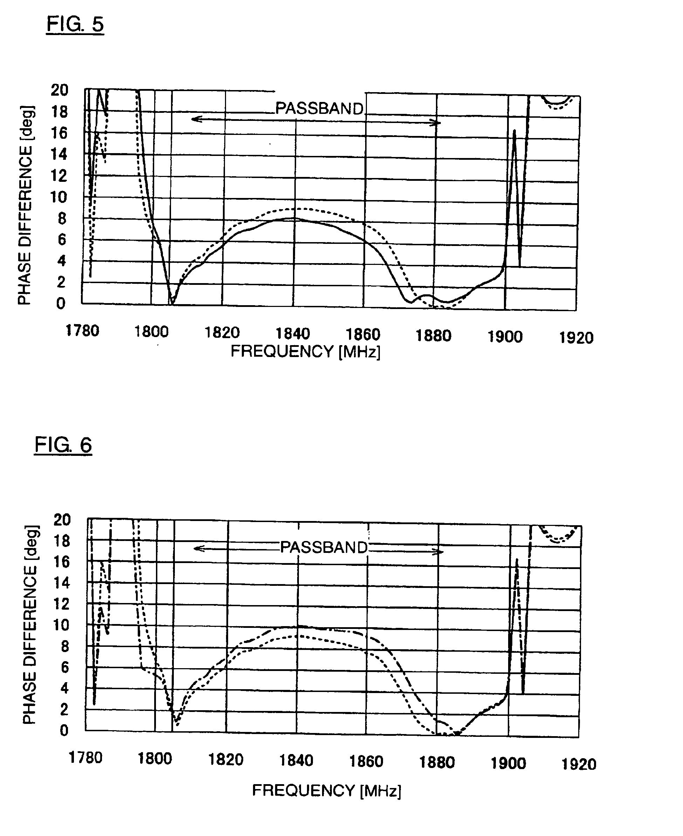

Next, the operation and advantages of the first preferred embodiment will be described. In Fig. 5, the solid line is used to indicate the result of the degree of phase balance in the first preferred embodiment. For comparison, in Fig. 5, the broken line is used to indicate the result of the degree of phase balance in a first example of the related art in which the electrode finger pitches of the IDTs 503 and 505 are set to be equal. The configuration of the first example of the related art is basically identical to the configuration of the first preferred embodiment except that the electrode finger pitches of the IDTs 503 and 505 are set to be equal. The passband of the DCS receiving filter is about 1805 MHz to about 1880 MHz.

According to Fig. 5, the degree of phase balance in this range is represented by a maximum of approximately 9 degrees in the first example of the related art, and is represented by a maximum of approximately 8 degrees in the first preferred embodiment, such that the degree of phase balance is improved by approximately one degree. This advantage is obtained by setting the electrode finger pitches of the first IDT 503 to be different from the second IDT 505.

In the first preferred embodiment, the electrode finger pitch of the IDT 503 is set to be greater than that of the IDT 505. Next, conversely therefrom, the result of the degree of phase balance in a case (first comparative example) in which the electrode finger pitch of the IDT 505 is set to be greater than that of the IDT 503 is studied. In Fig. 6, the result of the degree of phase balance in the case is indicated by the alternate long and short dash line. For comparison, the result of the degree of phase balance in the first example of the related art is also shown in Fig. 6. In this case, in the first comparative example, the degree of phase balance deteriorates as compared to the first example of the related art. The particular one of the balanced signal terminals in which a ground capacitance is to be increased is determined by the arrangement of adjacent electrode fingers in the IDTs 503 and 505.

In the case of the first preferred embodiment, electrode fingers (outermost electrode fingers) of the IDT 504 which are adjacent to the IDTs 503 and 505 are neutral electrodes (ground electrodes), and an electrode finger of the IDT 503 adjacent to the IDT 504 is a ground electrode. In the case of the arrangement of these electrode fingers, as in the first preferred embodiment, by setting the electrode finger pitch of the IDT 503 to be greater than that of the IDT 505, the degree of balance between balanced signal terminals is improved.

### Second Preferred Embodiment

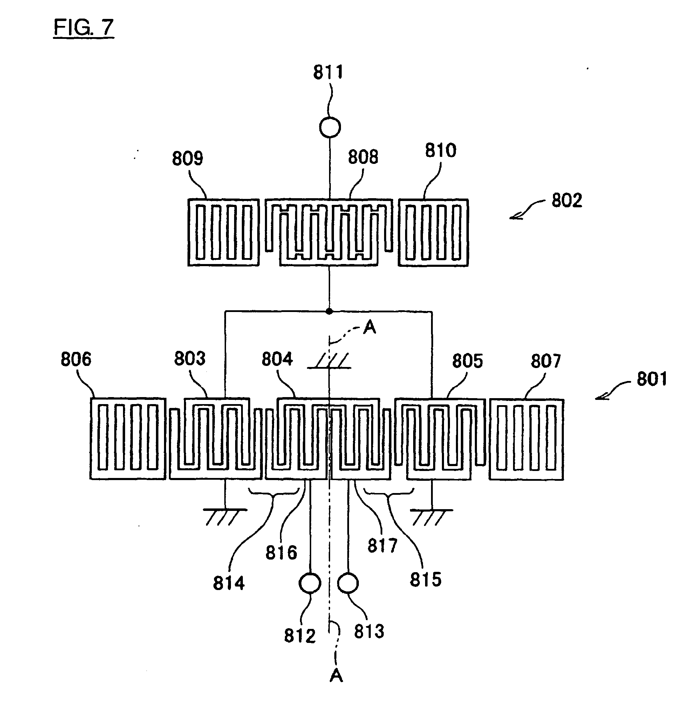

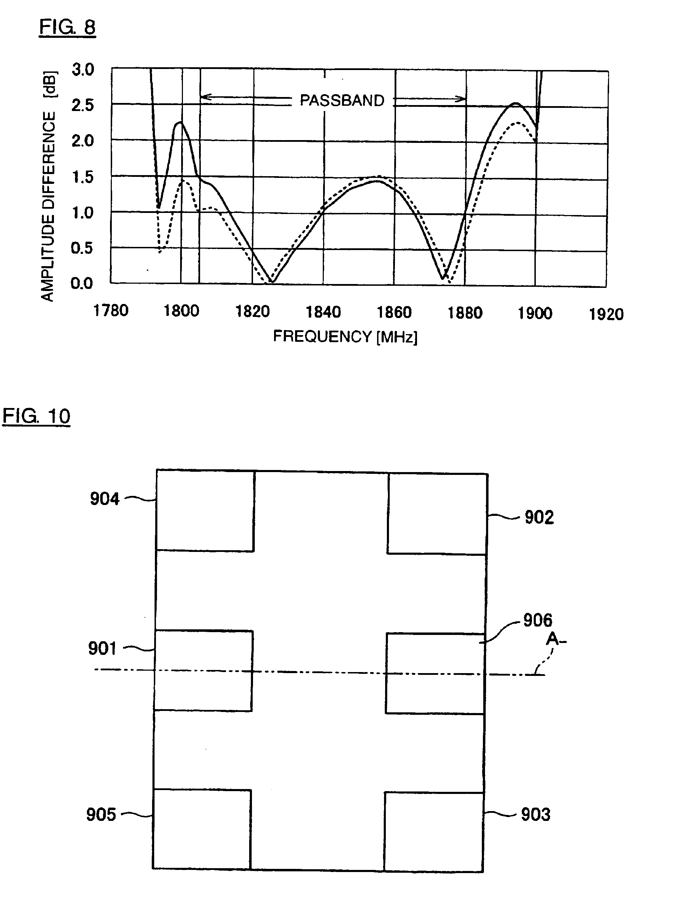

Next, a case in which, as shown in Fig. 7, electrode fingers (outermost electrode fingers) of an IDT 804 as a central interdigital transducer which are adjacent to first and second IDTs 803 and 805 are signal electrodes is provided as a second preferred embodiment. In Fig. 8, the solid line is used to indicate the result of the degree of amplitude balance in the second preferred embodiment, in which, in the configuration of Fig. 7, the electrode finger pitch of the second IDT 805 in which an electrode finger adjacent to the IDT 304 is a signal electrode is preferably set to be, for example, about 0.001 µm greater than that of the first IDT 803 in which an electrode finger adjacent to the IDT 804 is a ground electrode. For comparison, in Fig. 8, the broken line is used to indicate the result of the degree of amplitude balance in a second example of the related art in which the electrode finger pitches of the IDTs 803 and 805 are set to be equal. The second example of the related art is basically identical to the second preferred embodiment in the design of the surface acoustic wave filter, layouts on the piezoelectric substrate and package mounting method, except that the electrode finger pitches of the IDTs 803 and 805 are set to be equal.

Fig. 8 indicates that, in the second preferred embodiment, the degree of amplitude balance is improved by approximately 0.2 dB as compared to the second example of the related art. In other words, when electrode fingers adjacent to the IDTs 803 and 805 are signal electrodes, by increasing the electrode finger pitch of the IDT 805 in which the electrode finger adjacent to the IDT 804 is a signal electrode, as compared to the IDT 803 in which the electrode finger adjacent to the IDT 804 is a ground electrode, the balance between balanced signal terminals is improved.

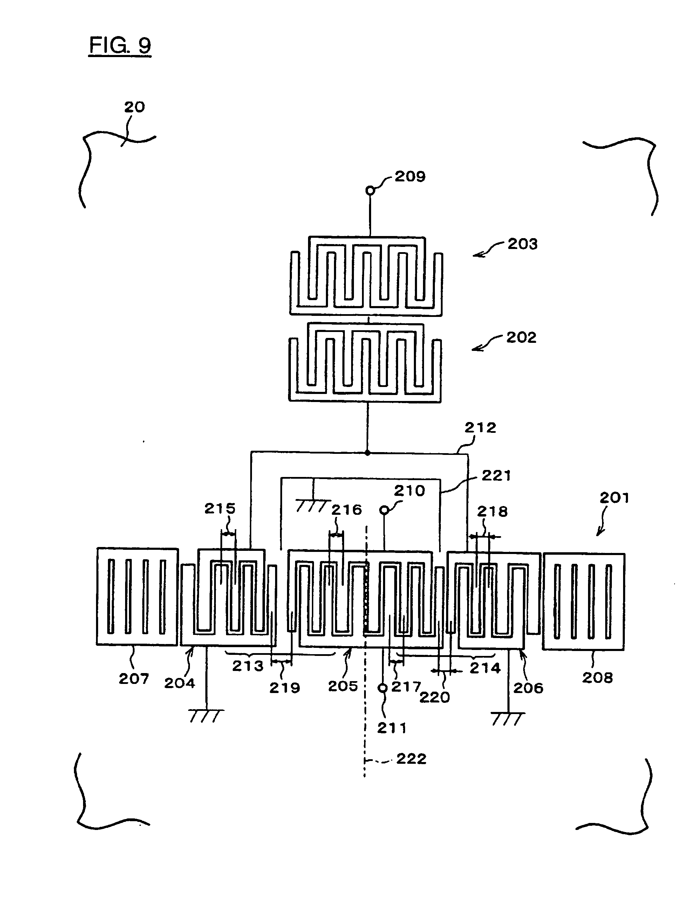

The present invention improves the degree of balance by setting design parameters on the right and left sides (areas separated by the imaginary central axis A) with respect to the imaginary central axis A to be different from one another. However, as Fig. 9 shows, Japanese Unexamined Patent Application Publication No. 2003-046369 describes a configuration in which, in a surface acoustic wave filter having a balance-unbalance conversion function established by extracting signals from two ends of an IDT 205, design parameters on the right and left with respect to the imaginary central axis 222 are set to be different.

The configuration in the invention described in the above publication is similar to the present invention in setting design parameters on the right and left to be different. However, as shown in Fig. 9, it does not include any neutral point as shown in Fig. 1, and balanced signals are extracted from two ends of one IDT (from both comb electrodes).

Accordingly, in the configuration in the above-mentioned publication, the fact that surface acoustic waves, propagated from IDTs 204 to 205, and from the IDT 206 to 205, are asymmetrically configured by setting the design parameters on the right and left to be different does not affect the degree of balance at all.

In the configuration of the publication, by setting the design parameters on the right and left to be different, in portions in which the IDTs 204 and 205 are adjacent and the IDTs 205 and 206 are adjacent, capacitances are asymmetrical. Therefore, only a change in parasitic capacitance at each of balanced signal terminals 210 and 211 affects the degree of balance.

Conversely, in the configuration in a preferred embodiment of the present invention, in Fig. 1, the IDT 504 is bisected in the surface-acoustic-wave propagation direction, and an electrode finger on a side to which a balanced signal terminal is not connected is grounded. Thus, by performing right-and-left asymmetrical design, in addition to the fact that capacitances are asymmetrical in portions in which the IDTs 503 and 504 are adjacent and the IDTs 504 and 504 are adjacent, the fact that the surface acoustic waves propagated from the IDT 503 to 504 and from the IDT 505 to 504 are made asymmetrical also affects the degree of balance.

In the present preferred embodiment of the present invention, by bisecting the IDT 504 in the surface-acoustic-wave propagation direction, and utilizing, in a surface acoustic wave filter provided with a balance-unbalance conversion function, operations and advantages different from those in Japanese Unexamined Patent Application Publication No. 2003-046369, the degree of balance is improved.

As described above, in the first and second preferred embodiments of the present invention, in a surface acoustic wave filter which has a longitudinally-coupled-resonator surface acoustic wave filter having an odd number of at least three interdigital transducers arranged in the surface-acoustic-wave propagation direction on a piezoelectric substrate, that is, IDTs, and in which, among the odd number of IDTs, one comb electrode of the IDT in the approximate center is bisected in the surface-acoustic-wave propagation direction and the polarities of adjacent IDTs on the right and left are inverted to establish a balance-unbalance conversion function, by setting the electrode finger pitches of the right and left IDTs to be different from one another, the degree of balance between balanced signal terminals of the surface acoustic wave filter is improved.

In addition, in the first preferred embodiment of the present invention, to eliminate an unnecessary unbalanced component, layouts on the piezoelectric substrate and the package are basically identical, except that the electrode finger pitches of the right and left IDTs are set to be different from one another. Accordingly, a case in which the number of back surface terminals on a package is five has been shown. The present invention is not limited to this package. Any package may be used as long as it is axially symmetrical with respect to the imaginary central axis A, which is vertically drawn in the surface-acoustic-wave propagation direction at a location between the first and second divided comb electrodes of the central IDT.

For example, in the case of a package having six terminals as shown in Fig. 10, by using a terminal 901 as an unbalanced signal terminal, terminals 902 and 903 as balanced signal terminals, and using terminals 904 to 906 as gate terminals, axial asymmetry with respect to an imaginary central axis A is established. In addition, in the first and second preferred embodiments, as in Fig. 4, a surface acoustic wave filter is produced by using a face-down technique to establish conduction between the package and the piezoelectric substrate. However, alternatively, a wire bond technique could be used.

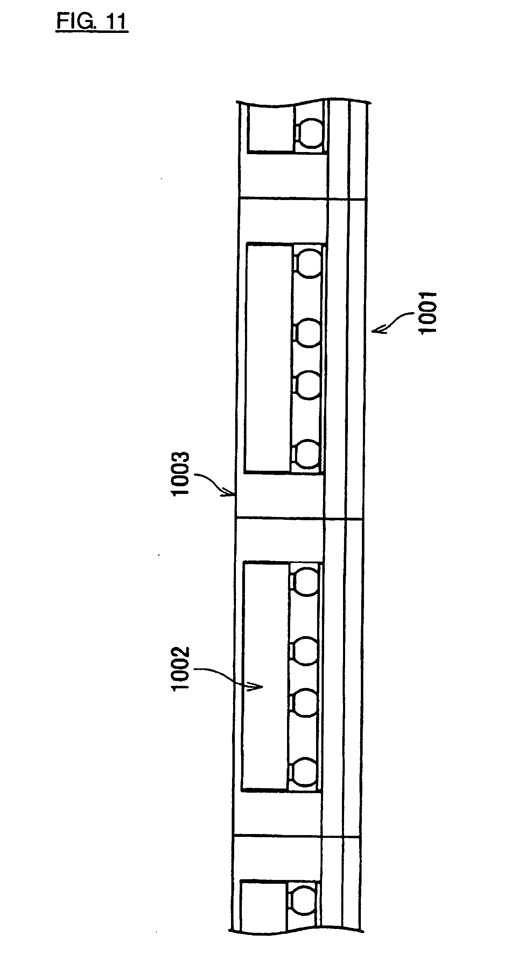

The configuration produced by a face-down technique is not limited to the configuration in Fig. 4. For example, a surface acoustic wave filter may be produced in which, as shown in Fig. 11, a piezoelectric substrate 1002 is bonded to a collective substrate 1001 by a flip chip technique, covered with a sealing resin material 1003, and then cut into units of packages by dicing, or in which, similarly, a piezoelectric substrate 1102 is bonded to a collective substrate 1101 by a flip chip technique, covered with a sealing resin material 1103, and cut into units of packages by dicing.

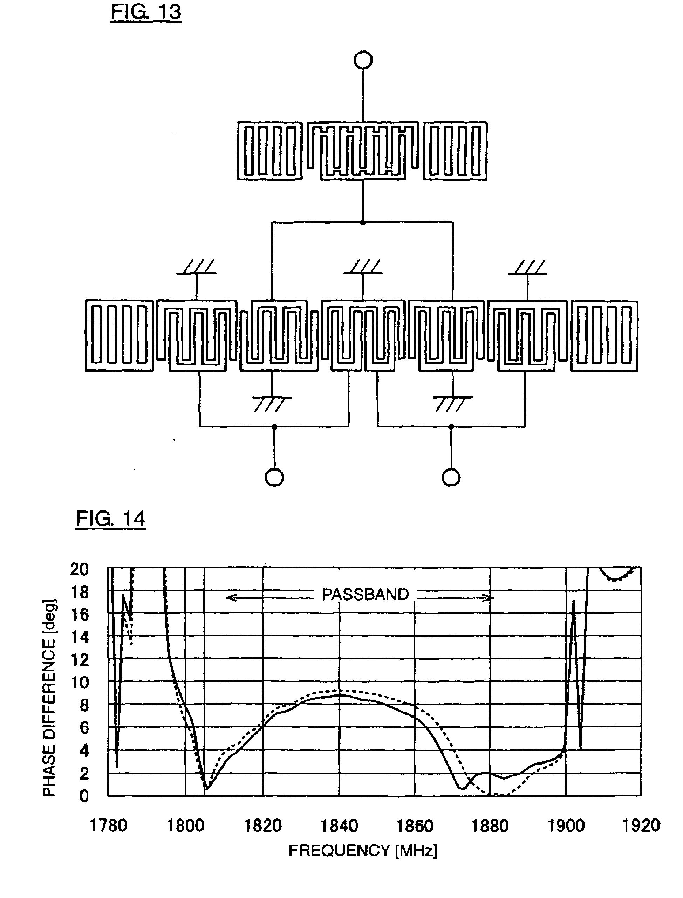

Each of the first and second preferred embodiments show a configuration in which a surface acoustic wave resonator is connected in series to a longitudinally-coupled-resonator surface acoustic wave filter portion having three IDTs. However, similar advantages can be obtained even in a configuration in which a surface acoustic wave resonator is not connected, and, in addition, in a configuration in which a surface acoustic wave resonator is connected in parallel. As shown in Fig. 13, a configuration having five IDTs may also be used.

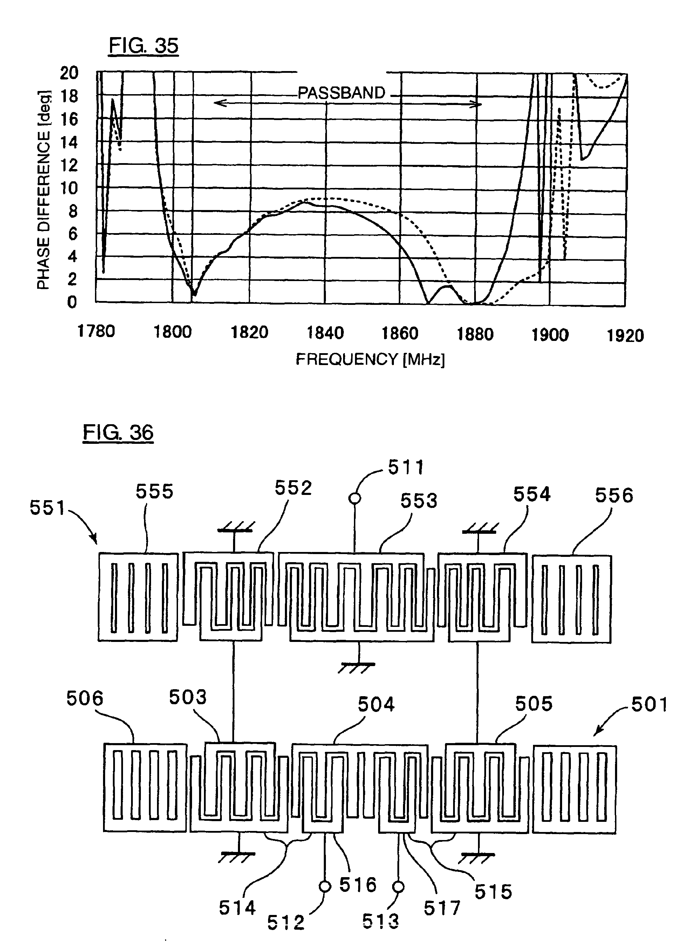

In addition, as shown in Fig. 36, a configuration in which a second longitudinally-coupled-resonator surface acoustic wave filter portion 551 is cascade-connected to the longitudinally-coupled-resonator surface acoustic wave filter portion 501 shown in Fig. 1 may be provided.

The second longitudinally-coupled-resonator surface acoustic wave filter portion 551 is cascade-connected to a stage prior to the longitudinally-coupled-resonator surface acoustic wave filter portion 501. The second longitudinally-coupled-resonator surface acoustic wave filter portion 551 has three IDTs 552 to 554 and reflectors 555 and 556 provided at both ends in a surface acoustic wave propagation direction of an area in which the IDTs 552 to 554 are provided. The IDT 553 in the approximate center is electrically connected to an unbalanced terminal 511. The IDTs 552 and 554 disposed on both sides of the IDT 553 are connected to the IDTs 503 and 505 of the second longitudinally-coupled-resonator surface acoustic wave filter portion 551, respectively. In this case, it is preferable that, in the IDT 553 located in the approximate center of the second longitudinally-coupled-resonator surface acoustic wave filter portion 551, the total number of electrode fingers be odd. It is preferable to adjust the orientation of each IDT such that the phases of signals, for transmission on signal lines connecting the longitudinally-coupled-resonator surface acoustic wave filter portion 501 and the second longitudinally-coupled-resonator surface acoustic wave filter portion, differ from one another by approximately 180 degrees. By using the above-described configuration, a surface acoustic wave filter having an outstanding degree of balance is obtained.

In addition, in each of the first and second preferred embodiments, all of the pitches of the IDT 503 (803) and the IDT 505 (805) are set to be different from one another. However, only some pitches may be set to be different. In each of the first and second preferred embodiments, a 40±5°-Y-cut-X-propagation LiTaO₃ substrate is preferably used. However, similar advantages can be obtained by using other substrates, such as 64°-to-72°-Y-cut-X-propagation LiNbO₃ and Y-cut-X-propagation LiNbO₃.

### First Additional Arrangement

The basic configuration of a first additional arrangement is basically identical to that of the first preferred embodiment. In the first additional arrangement, in Fig. 1, between the bisected comb electrodes 516 and 517 of the IDT 504, the electrode finger pitch of the divided comb electrode 516 located closer to the IDT 503 in which an electrode finger adjacent to IDT 503 is a ground electrode is preferably set to be, for example, about 0.001 µm greater than the divided comb electrode 517 located closer to the IDT 505 in which an electrode finger adjacent to the IDT 504 is a signal electrode.

The result of the degree of phase balance in the first additional arrangement is indicated by the solid line in Fig. 14. For comparison, the broken line is used to indicate the result of the degree of the phase balance in the first example of the related art in Fig. 14. In the first additional arrangement, the degree of phase balance is improved as compared to the first example of the related art.

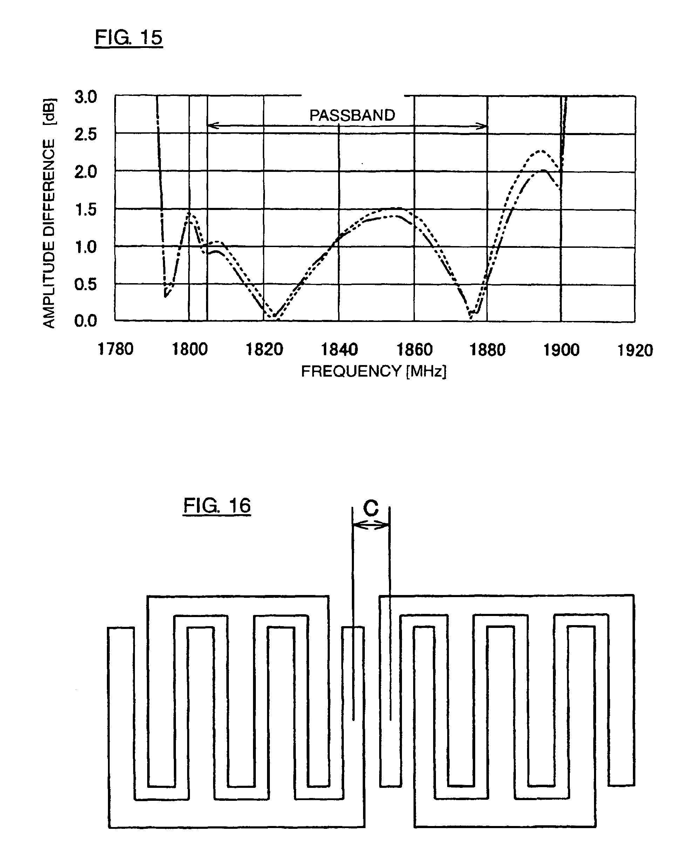

Next, in Fig. 15, the two-dot chain line is used to indicate the result of amplitude balance in a case (one modification) in which, in the configuration in Fig. 7, between the first and second bisected comb electrodes 816 and 817 of the IDT 804, the electrode finger pitch of the first bisected comb electrode 816 which is closer to the first IDT 803 and in which an electrode finger adjacent to the IDT 804 is a ground electrode is preferably set to be, for example, about 0.001 µm greater than that of the second divided comb electrode 817 closer to the second IDT 805 in which an electrode finger adjacent to the IDT 804 is a signal electrode. For comparison, in Fig. 15, the broken line is used to indicate the result of the degree of amplitude balance in the second example of the related art in which the electrode finger pitches of the first and second bisected comb electrodes 816 and 817 are set to be equal.

In the one modification of the first additional arrangement, the degree of amplitude balance is improved as compared to the second example of the related art. In other words, when setting the pitches of bisected comb electrodes to be different from one another, as in the first additional arrangement by increasing the pitch of an IDT closer to another IDT in which an electrode finger adjacent to the bisected comb electrode is a ground electrode, regardless of the polarities of electrode fingers adjacent to right and left IDTs of the bisected comb electrodes, the balance between balanced signal terminals of a surface acoustic wave filter is improved.

In addition, in the first additional arrangement, the pitch of the first bisected comb electrode 516 (816) and the pitch of the second bisected comb electrode 517 (817) are set to be different from one another preferably in all the portions. However, the pitch may be set to be different in only in some portions.

### Second Additional Arrangement

The basic configuration of the second additional arrangement is basically identical to that of the first preferred embodiment. However, in the second additional arrangement, in Fig. 1, the electrode-finger center-to-center distance (the distance denoted by reference alphabet C in Fig. 16) between outermost electrode fingers of the IDT 504 and the first IDT 503 in which the electrode finger adjacent to the IDT 504 is a ground electrode is preferably set to be, for example, about 0.002λI (U: a wavelength determined by an IDT electrode finger pitch) greater than the electrode-finger center-to-center distance between outermost electrode fingers of the IDT 504 and the second IDT 505 in which the electrode finger adjacent to the IDT 504 is a signal electrode.

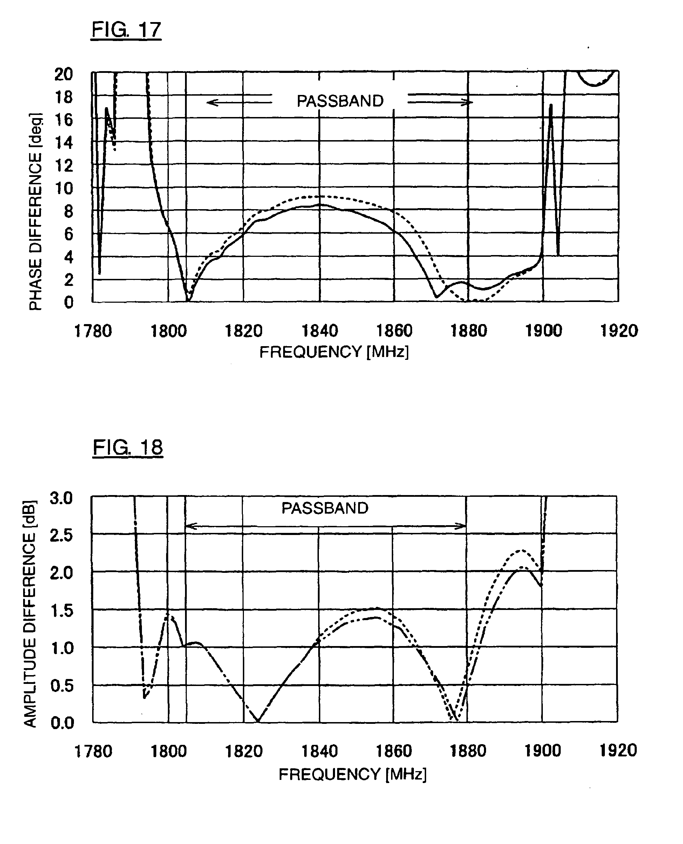

Next, the result of the degree of phase balance in the configuration of the second additional arrangement is indicated by the solid line in Fig. 17. For comparison, in Fig. 17, the broken line is used to indicate the result of the degree of phase balance in the first example of the related art, in which the electrode-finger center-to-center distance between the outermost electrode fingers of the IDTs 504 and 503 and the electrode-finger center-to-center distance between the outermost electrode fingers of the IDTs 504 and 505 are set to be equal. In the second additional arrangement, the degree of phase balance is improved as compared to the first example of the related art.

Next, in Fig. 18, the two-dot chain line is used to indicate the result of the degree of amplitude balance in a case (one modification) in which, in the configuration of Fig. 7, the electrode-finger center-to-center distance between outermost electrode fingers of the IDT 804 and the IDT 803 in which the electrode finger adjacent to the IDT 804 is a signal electrode is preferably set to be, for example, about 0.002λI greater than the electrode-finger center-to-center distance of the second IDT 805 in which the electrode finger adjacent to the IDT 804 is a signal electrode. For comparison, in Fig. 18, the broken line is used to indicate the second example of the related art, in which the electrode-finger center-to-center distance between the outermost electrode fingers of the IDTs 804 and 803 and the electrode-finger center-to-center distance between the outermost electrode fingers of the IDTs 804 and 805 are set to be equal.

In the one modification of the second additional arrangement, the degree of amplitude balance is improved as compared to the second example of the related art. In other words, when setting the electrode-finger center-to-center distance between outermost electrode fingers of a bisected comb electrode and right or left IDT, as in the second additional arrangement, regardless of the polarities of electrode fingers adjacent to right and left IDTs of the bisected comb electrode, by increasing the electrode-finger center-to-center distance between the outermost electrode fingers of an IDT closer to an IDT in which an electrode finger adjacent to the bisected comb electrode is a ground electrode, and the bisected comb electrode, the degree of balance between balanced signal terminals of the surface acoustic wave filter is improved.

### Third Additional Arrangement

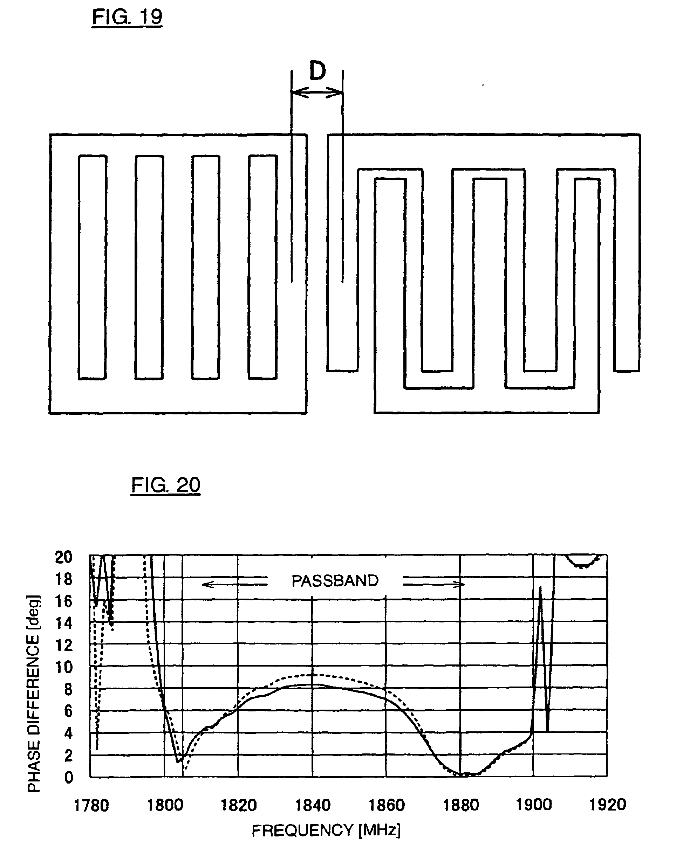

The basic configuration of the third additional arrangement is basically identical to that of the first preferred embodiment. However, in the third additional arrangement, in Fig. 1, an electrode-finger center-to-center distance (the distance indicated by reference alphabet C in Fig. 19) of outermost electrode fingers among the IDT 504, the first IDT 503 in which the electrode finger adjacent to the IDT 504 is a ground electrode, and the first reflector 506 is preferably set to be, for example, about 0.01λI greater than an electrode-finger center-to-center distance of outermost electrode fingers among the IDT 504, the second IDT 505 in which the electrode finger adjacent to the IDT 504 is a signal electrode, and the second reflector 507.

In Fig. 20, the solid line is used to indicate the degree of phase balance in the configuration of the third additional arrangement. For comparison, in Fig. 20, the broken line is used to also the result of the degree of phase balance in the first example of the related art, in which the electrode-finger center-to-center distance between outermost electrode fingers between the IDT 503 and the reflector 506, and the electrode-finger center-to-center distance between outermost electrode fingers between the IDT 505 and the reflector 507 are set to be equal. It can be understood that, in the third additional arrangement, the degree of phase balance is improved as compared to the first example of the related art.

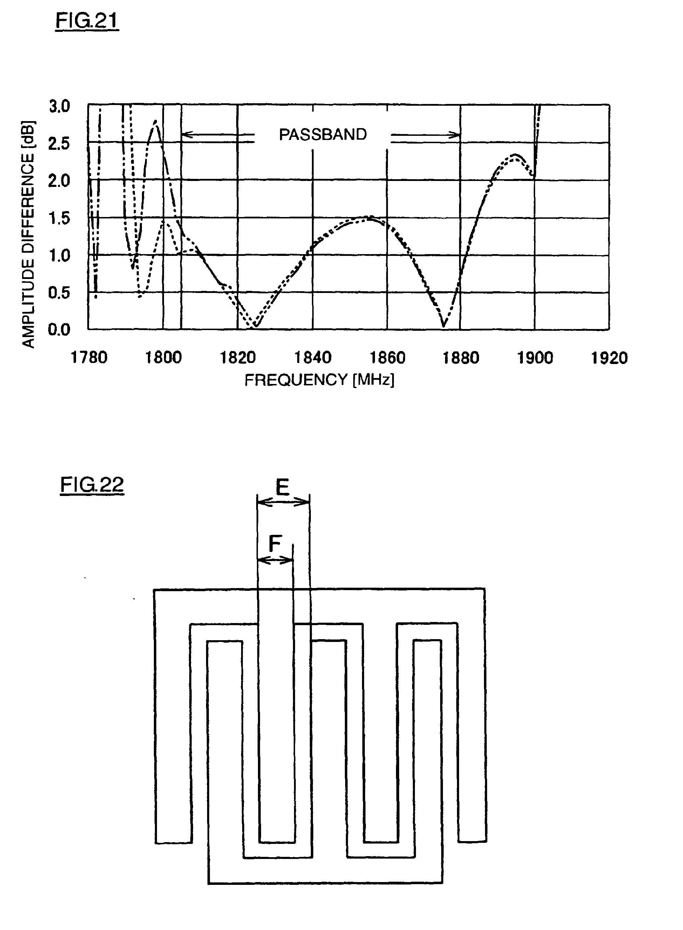

Next, in Fig. 21, the two-dot chain line is used to indicate the result of the degree of amplitude balance in a case (one modification) in which the electrode-finger center-to-center distance between outermost electrode fingers of the second IDT 805 in which the electrode finger adjacent to the IDT 804 is a signal electrode and the second reflector 807 is preferably set to be, for example, about 0.01λI greater than the electrode-finger center-to-center distance between outermost electrode fingers of the first IDT 803 and the first reflector 806. For comparison, in Fig. 21, the broken line is used to indicate the result of the degree of amplitude balance in the second example of the related art, in which the electrode-finger center-to-center distance between outermost electrode fingers of the IDT 803 and the reflector 806, and the electrode-finger center-to-center distance between outermost electrode fingers of the IDT 805 and the reflector 807 are set to be equal.

In the one modification of the third additional arrangement, the degree of amplitude balance is improved as compared to the second example of the related art. In other words, in the case of setting a difference in electrode-finger center-to-center distance between a right or left IDT and a reflector, as in the third additional arrangement, when an electrode finger of a bisected comb electrode which is adjacent to a right or left IDT is a neutral electrode, the distance between an IDT in which an electrode finger adjacent to the bisected comb electrode is a signal electrode and the reflector is increased, and, when an electrode finger of the bisected comb electrode which is adjacent to the right or left IDT is a signal electrode, the distance between an IDT in which an electrode finger adjacent to the bisected signal electrode and the reflector is increased, whereby the degree of balance between balanced signal terminals of the surface acoustic wave filter is improved.

### Fourth Additional Arrangement

The basic configuration of the fourth additional arrangement is basically identical to that of the first preferred embodiment. However, in the fourth additional arrangement, in Fig. 1, the duty ratio (F/E in Fig. 22) of electrode fingers of the first IDT 503 in which the electrode finger adjacent to the IDT 504 is a ground electrode is preferably set to be, for example, about 0.04 greater than the duty ratio of electrode fingers of the second IDT 505 in which the electrode finger adjacent to the IDT 504 is a signal electrode.

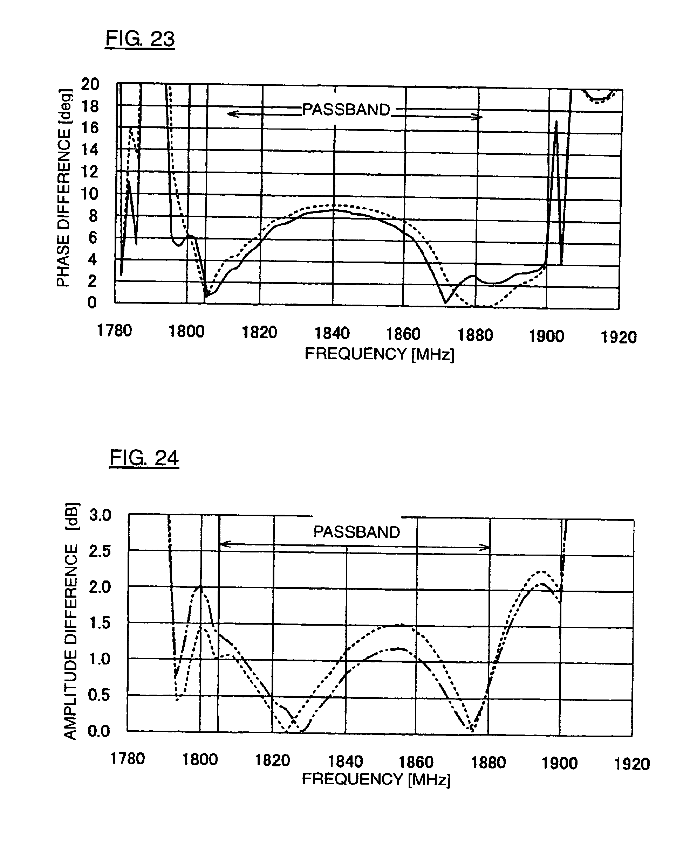

In Fig. 23, the solid line is used to indicate the result of the degree of phase balance in the configuration of the fourth additional arrangement. For comparison, in Fig. 23, the broken line is used to indicate the result of the degree of phase balance in the first example of the related art, in which the duty ratio of electrode fingers of the IDT 503 and the duty of electrode fingers of the IDT 505 are set to be equal. The degree of phase balance is improved as compared to the first example of the related art.

Next, in Fig. 24, the two-dot chain line is used to indicate the result of the degree of amplitude balance in a case (one modification) in which, in the configuration of Fig. 7, the duty ratio of electrode fingers of the first IDT 803 in which the electrode finger adjacent to the IDT 804 is a ground electrode is preferably set to be, for example, about 0.04 greater than the duty ratio of electrode fingers of the second IDT 805 in which the electrode finger adjacent to the IDT 804 is a signal electrode. For comparison, in Fig. 24, the broken line is used to indicate the result of the degree of amplitude balance in the second example of the related art.

In the one modification of the fourth additional arrangement, the degree of amplitude balance is improved as compared to the second example of the related art. In other words, when setting a difference in duty ratio between the right and left electrode fingers, as in the fourth additional arrangement, regardless of the polarities of electrode fingers adjacent to right and left IDTs of bisected comb electrodes, by increasing the duty ratio of electrode fingers of an IDT closer to an IDT in which an electrode finger adjacent to the bisected comb electrode is a ground electrode, the balance between balanced signal terminals of the surface acoustic wave filter in improved. In addition, in the fourth additional arrangement, all of the duty ratioes of the IDT 503 (803) and the IDT 505 (805) are set to be different from one another. However, only some of the duty ratioes may be set to be different.

### Fifth Additional Arrangement

The basic configuration of the fifth additional arrangement is basically identical to that of the first preferred embodiment. However, in the fifth additional arrangement, in Fig. 1, between the bisected comb electrodes 516 and 517 of the IDT 504, the duty ratio of electrode fingers of the first bisected comb electrode 516 closer to the first IDT 503 in which the electrode finger adjacent to the IDT 504 is a ground electrode is preferably set to be about, for example, 0.04 greater than the duty ratio of electrode fingers of the second bisected comb electrode 517 closer to the second IDT 505 in which the electrode finger adjacent to the IDT 504 is a signal electrode.

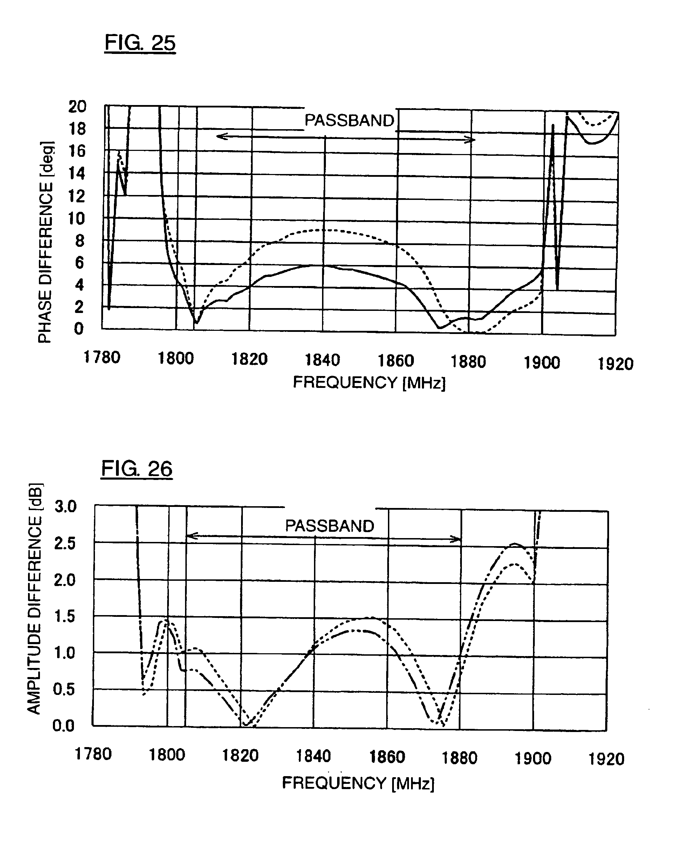

In Fig. 25, the solid line is used to indicate the result of the degree of phase balance in the configuration of the fifth additional arrangement. For comparison, in Fig. 25, the broken line is used to indicate the result of the degree of phase balance in the first example of the related art, in which the duty ratio of electrode fingers of the bisected comb electrode 516 and the duty ratio of electrode fingers of the bisected comb electrode 517 are set to be equal. In the fifth additional arrangement, the degree of phase balance is improved as compared to the first example of the related art.

Next, in Fig. 26, the two-dot chain line is used to indicate the result of the degree of phase balance in a case (one modification) in which, in the configuration of Fig. 7, between the bisected comb electrodes of the IDT 804, the duty ratio of electrode fingers of the second bisected comb electrode 817 closer to the IDT 805 in which the electrode finger adjacent to the IDT 804 is a signal electrode is preferably set to be, for example, about 0.04 greater than the duty ratio of electrode fingers of the first bisected comb electrode 816 closer to the first IDT 803 in which the electrode finger adjacent to the first IDT 803 is a ground electrode. For comparison, in Fig. 26, the broken line is used to indicate the result of the degree of amplitude balance in the second example of the related art, in which the duty ratio of electrode fingers of the first bisected comb electrode 816 and the duty ratio of electrode fingers of the second bisected comb electrode 817 are set to be equal.

In the one modification of the fifth additional arrangement, the degree of amplitude balance is improved as compared to the second example of the related art. In other words, in the case of setting a difference in duty ratio between the bisected comb electrodes, as in the fifth additional arrangement when an electrode finger of the bisected comb electrode which is adjacent to the right or left IDT is a neutral electrode, by increasing the ratio of a comb electrode closer to an IDT in which an electrode finger adjacent to the bisected comb electrode is a ground electrode, and, when an electrode finger of the bisected comb electrode which is adjacent to the right or left IDT is a signal electrode, by increasing, for that of the opposite comb electrode, the ratio of the bisected comb electrode closer to the an IDT in which an electrode finger adjacent to the bisected comb electrode is a signal electrode, the degree of balance between balanced signal terminals of the surface acoustic wave filter is improved. In addition, in the fifth additional arrangement, all of the duty ratioes of the bisected comb electrode 516 (816) and the bisected comb electrode 517 (817) are set to different from one another. However, only some of the duties may be set to be different.

### Sixth Additional Arrangement

The basic configuration of the fifth additional arrangement is basically identical to that of the first preferred embodiment. However, in the sixth additional arrangement, in Fig. 1, the pitch of narrow pitch electrode fingers in an area where the first IDT 503 in which the electrode finger adjacent to the IDT 504, and the IDT 504 are adjacent to each other is preferably set to be, for example, about 0.004λI greater than the pitch of narrow pitch electrode fingers in an area where the second IDT 505 in which the electrode finger adjacent to the IDT 504 is a signal electrode and the IDT 504 are adjacent to each other.

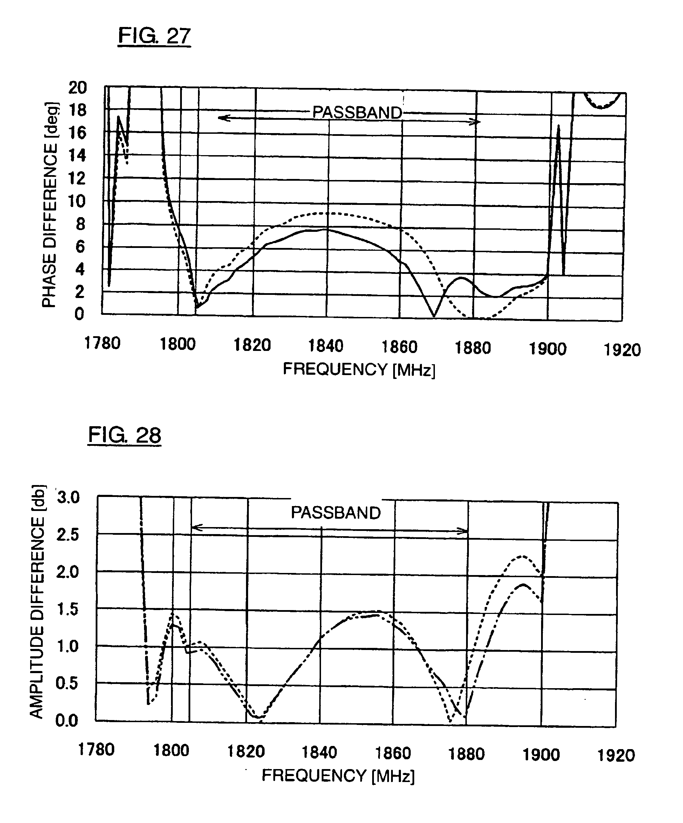

In Fig. 27, the solid line is used to indicate the result of the degree of phase balance in the configuration of the sixth additional arrangement. For comparison, in Fig. 27, the broken line is used to indicate the result of the degree of phase balance in the first example of the related art, in which the pitch of narrow pitch electrode fingers between the IDTs 503 and 504 and the pitch of narrow pitch electrode fingers between the IDTs 505 and 504 are set to be equal. In the sixth additional arrangement, the degree of phase balance is improved as compared to the first example of the related art.

Next, in Fig. 28, the two-dot chain line is used to indicate the result of the degree of amplitude balance in a case (one modification) in which, in the configuration in Fig. 7, the pitch of narrow pitch electrode fingers in the area where the first IDT 803 in which the electrode finger adjacent to the IDT 804 is a ground electrode and the IDT 804 are adjacent to each other is preferably set to be, for example, about 0.004λI greater than the pitch of narrow pitch electrode fingers in the area where the second IDT 805 in which the electrode finger adjacent to the IDT 804 is a signal electrode and the IDT 804 are adjacent to each other. For comparison, in Fig. 28, the broken line is used to indicate the result of the degree of amplitude balance in the second example of the related art, in which the pitch of narrow pitch electrode fingers between the IDTs 803 and 804 and the pitch of narrow pitch electrode fingers between the IDTs 805 and 804 are set to be equal.

In the one modification of the sixth additional arrangement, the degree of amplitude balance is improved as compared to the second example of the related art. In other words, when setting a difference in pitch of narrow pitch electrode fingers between the right and left, as in the sixth additional arrangement regardless of the polarities of electrode fingers adjacent to right and left IDTs of bisected comb electrodes, by increasing the pitch of narrow pitch electrode fingers in an area where a bisected comb electrode closer to an IDT in which an electrode finger adjacent to the bisected comb electrode is a ground electrode and the bisected comb electrode are adjacent to each other, the degree of balance between balanced signal terminals of the surface acoustic wave filter is improved.

### Seventh Additional Arrangement

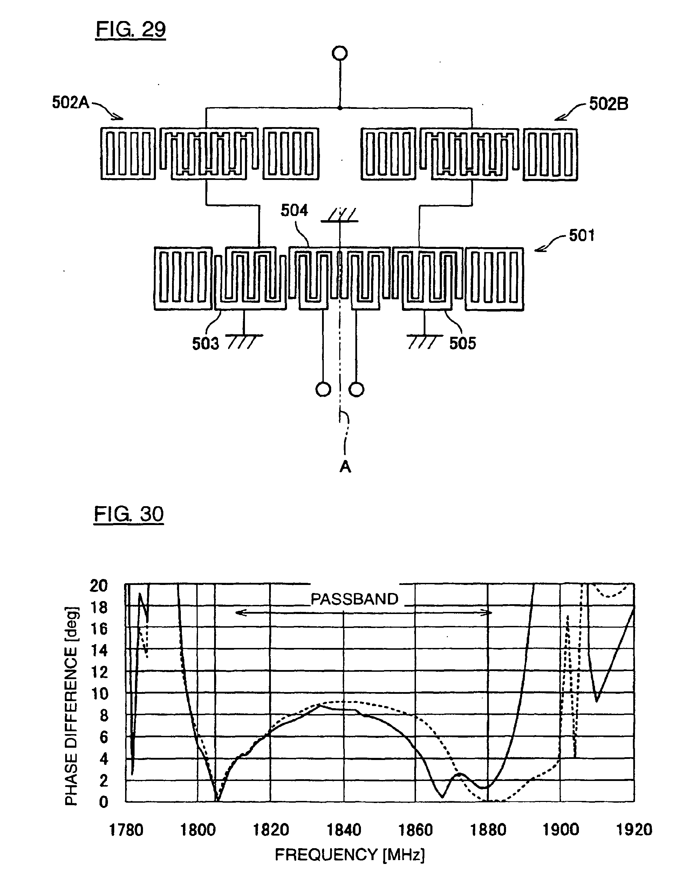

The configuration of a seventh additional arrangement of the present invention is shown in Fig. 29. The configuration of the longitudinally-coupled-resonator surface acoustic wave filter portion 501 according to the seventh additional arrangement is basically identical to that of the first preferred embodiment. However, two surface acoustic wave resonators are further provided and are connected to the IDTs 503 and 505, respectively. In this case; the electrode finger pitches of an IDT and reflector of a surface acoustic wave resonator 502A connected to the first IDT 503 in which the electrode finger adjacent to the IDT 504 is a ground electrode is preferably set to be, for example, about 0.004λI (λ: a wavelength determined by the electrode finger pitch of a surface acoustic wave resonator) greater than a surface acoustic wave resonator 502B connected to the second IDT 505 in which the electrode finger adjacent to the IDT 504 is a signal electrode. The designs of the surface acoustic wave resonators 502A and 502B are basically identical except that their electrode finger pitches differ from each other.

In Fig. 30, the solid line is used to indicate the result of the degree of phase balance in the configuration of the seventh additional arrangement. For comparison, in Fig. 30, the broken line is used to indicate the result of the degree of phase balance in a third example of the related art in which the electrode finger pitches of the surface acoustic wave resonators 502A and 502B are set to be equaL In the seventh additional arrangement, the degree of phase balance is improved as compared to the third example of the related art.

When surface acoustic wave resonators are respectively connected to the IDTs 503 and 505 and their electrode finger pitches are set to be different from one another, by increasing the electrode finger pitch of a first surface acoustic wave resonator, which is connected to the first IDT 503 in which the electrode finger adjacent to the bisected IDT 504 is a ground electrode, than the electrode finger pitch of a second surface acoustic wave resonator, which is connected to the second IDT 505 in which the electrode finger adjacent to the IDT 504 is a signal electrode, the degree of balance between balanced signal terminals is improved. This does not depend on the polarities of electrode fingers of the IDT 504 which are adjacent to the IDTs 503 and 505.

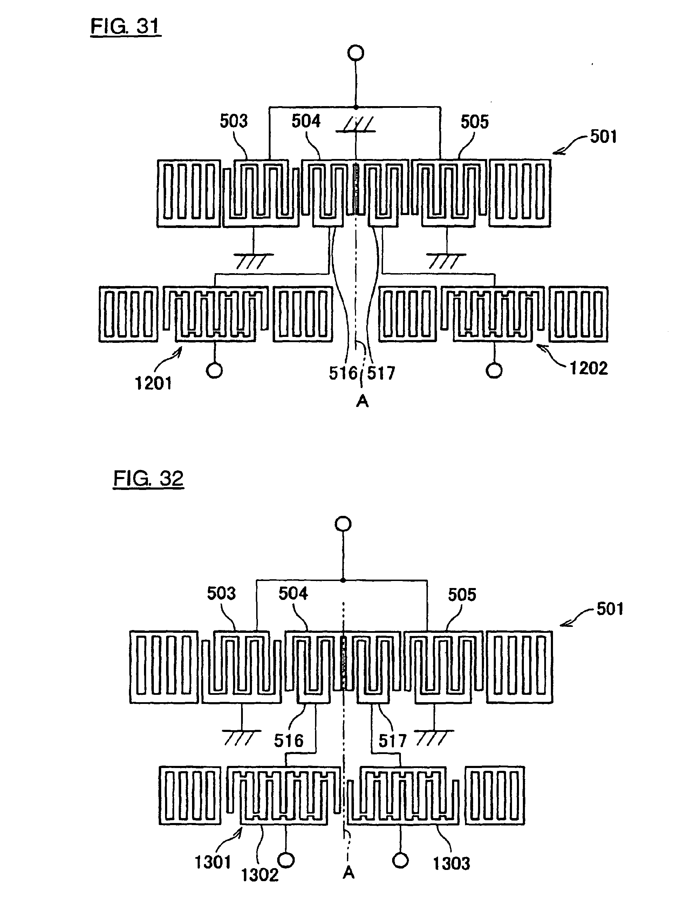

In the seventh additional arrangement, all of the electrode finger pitches of IDTs and reflectors of the surface acoustic wave resonators 502A and 502B are preferably set to be different from one another. However, the electrode finger pitch of only a portion of the electrode fingers may be set to be different. In addition, as Fig. 31 shows, surface acoustic wave resonators may be respectively connected to the first and second comb electrodes 516 and 517, and the electrode finger pitches of surface acoustic wave resonators 1201 and 1202 may be set to be different from one another.

In this case, by increasing the electrode finger pitch of the surface acoustic wave resonator 1201, which is connected to a first comb electrode 516 closer to the first IDT 503 in which the electrode finger adjacent to the IDT 504 is a ground electrode, than the electrode finger pitch of the surface acoustic wave resonator 1202 which is connected to the second comb electrode 517 closer to the second IDT 505 in which the electrode finger adjacent to the IDT 504 is a signal electrode, the degree of balance between balanced signal terminals is improved.

In addition, as shown in Fig. 32, instead of the above-described surface acoustic wave resonators, a two-terminal-pair surface acoustic wave resonator 1301 is preferably used. The electrode finger pitches of IDTs 1302 and 1303 of the two-terminal-pair surface acoustic wave resonator 1301 are set to be different from one another.

In this case, by increasing the electrode finger pitch of the IDT 1302, which is connected to the first divided comb electrode 516 closer to the IDT 503 in which the electrode finger adjacent to the IDT 504 is a ground electrode, than the electrode finger pitch of the IDT 1303, which is connected to a second bisected comb electrode 517 closer to the IDT 505 in which the electrode finger adjacent to the IDT 504 is a signal electrode, the degree of balance between balanced signal terminals is improved.

### Eighth Additional Arrangement

The configuration of a eighth additional arrangement of the present invention is basically identical to that of the seventh additional arrangement. However, the pitch ratio (IDT electrode finger pitch/reflector electrode finger pitch) of electrode fingers of an IDT and reflector of the first surface acoustic wave resonator 502A connected to the first IDT 503 in which the electrode finger adjacent to the IDT 504 is a ground electrode is preferably set to be, for example, about 0.01 less than that in the second surface acoustic wave resonator 502B connected to the second IDT 505 in which the electrode finger adjacent to the IDT 504 is a signal electrode. The designs of the surface acoustic wave resonators 502A and 502B are basically identical except that the pitch ratios of IDTs and reflectors are set to be different from one another.

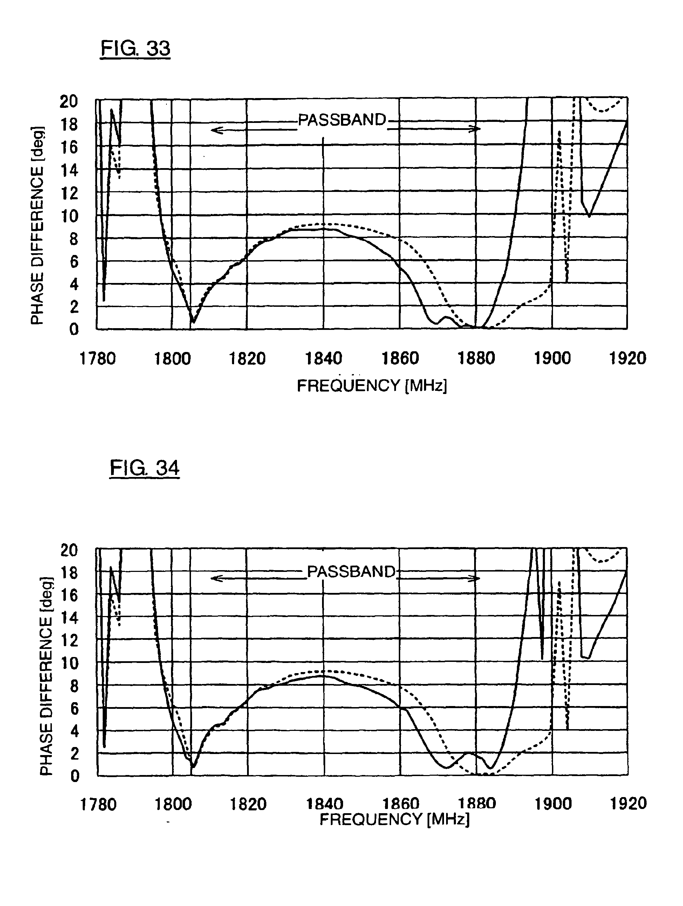

In Fig. 33, the solid line is used to indicate the result of the degree of phase balance in the configuration of the eighth additional arrangement. For comparison, in Fig. 33, the broken line is used to indicate the result of the degree of phase balance in the third example of the related art, in which the pitch ratios of IDTs and reflectors of the surface acoustic wave resonators 502A and 502B are set to be equal. In the eighth additional arrangement, the degree of phase balance is improved as compared to the third example of the related art.

When, as in the above preferred embodiments, surface acoustic wave resonators are respectively connected to the IDTs 503 and 505 and the pitch ratios of their IDTs and reflectors are set to be different from one another, by decreasing the pitch ratio of IDT and reflector of the surface acoustic wave resonator connected to the IDT 503 in which the electrode finger adjacent to the IDT 504 having first and second comb electrodes compared with the pitch ratio of IDT and reflector of the surface acoustic wave resonator connected to the IDT 505 in which the electrode finger adjacent to the IDT 504 is a signal electrode, the degree of balance between balanced signal terminals is improved. This does not depend on the polarities of electrode fingers of the IDT 504 which are adjacent to the IDTs 503 and 505.

In addition, as shown in Fig. 31, the first and second surface acoustic wave resonators may be respectively connected to the first and second comb electrodes, and the pitch ratios of IDs and reflectors of the first and second surface acoustic wave resonators 1201 and 1202 may be set to be different from one another.

In this case, by decreasing the pitch ratio of IDT and reflector of the surface acoustic wave resonator 1201, which is connected to the comb electrode 516 closer to the IDT 503 in which the electrode finger adjacent to the IDT 504 is a ground electrode, as compared to the pitch ratio of IDT and reflector of the surface acoustic wave resonator 1202 connected to the bisected comb electrode 517 closer to the IDT 505 in which the electrode finger adjacent to the IDT 504 is a signal electrode, the degree of balance between balanced signal terminals is improved.

### Ninth Additional Arrangement

The configuration of an ninth additional arrangement of the present invention is basically identical to that of the seventh additional arrangement. However, the electrode-finger center-to-center distance between outermost electrode fingers of the IDT and reflector of the first surface acoustic wave resonator 502A connected to the first IDT 503 in which the electrode finger adjacent to the IDT 504 is a ground electrode is preferably set to be, for example, about 0.06 greater than that of the second surface acoustic wave resonator 502B connected to the second IDT 505 in which the electrode finger adjacent to the IDT 504 is a signal electrode. The designs of the surface acoustic wave resonators 502A and 502B are basically identical except that the electrode-finger center-to-center distances between the outermost electrode fingers of the IDTs and reflectors are set to be different from one another.

In Fig. 34, the solid line is used to indicate the result of the degree of phase balance in the configuration of the ninth additional arrangement. For comparison, in Fig. 34, the broken line is used to indicate the result of the degree of phase balance in the third example of the related art, in which the electrode-finger center-to-center distances between outermost electrode fingers of IDTs and reflectors of the surface acoustic wave resonators 502A and 502B are set to be equal. In the ninth additional arrangement, the degree of phase balance is improved as compared to the third example of the related art.

When, as in the above preferred embodiments, surface acoustic wave resonators are respectively connected to the IDTs 503 and 505, and the electrode-finger center-to-center distances between the outermost electrode fingers of their IDTs and reflectors are set to be different from one another, by decreasing the electrode-finger center-to-center distance between outermost electrode fingers of the IDT and the reflector of the surface acoustic wave resonator connected to the IDT 503 in which the electrode finger adjacent to the IDT 504, which has bisected comb electrodes, compared with the electrode-finger center-to-center distance between outermost electrode fingers of the IDT and reflector of the surface acoustic wave resonator connected to the IDT 505 in which the electrode finger adjacent to the IDT 504 is a signal electrode, the degree of balance between balanced signal terminals is improved. This does not depend on the polarities of electrode fingers of the IDT 504 which are adjacent to the IDTs 503 and 505.

In addition, as shown in Fig. 31, the first and second surface acoustic wave resonators may be respectively connected to the first and second bisected comb electrodes 516 and 517, and the electrode-finger center-to-center distances between outermost electrode fingers of IDTs and reflectors of the first and second surface acoustic wave resonators 1201 and 1202 may be set to be different from one another. In this case, by decreasing the electrode-finger center-to-center distance between outermost electrode fingers of the IDT and reflector of the first surface acoustic wave resonator 1201 which is connected to the first bisected comb electrode 516 closer to the first IDT 503 in which the electrode finger adjacent to the IDT 504 is a ground electrode, as compared to the electrode-finger center-to-center distance between outermost electrode fingers of the IDT and reflector of the second surface acoustic wave resonator 1202 which is connected to the second bisected comb electrode 517 closer to the second IDT 505 in which the electrode finger adjacent to the IDT 504 is a signal electrode, the degree of balance between balanced signal terminals is improved.

### Tenth Additional Arrangement

The configuration of a tenth additional arrangement of the present invention is basically identical to that of the seventh additional arrangement. However, the duty ratioes of the IDT and reflector of the first surface acoustic wave resonator 502A, which is connected to the first IDT 503 in which the electrode finger adjacent to the IDT 504 is a ground electrode are preferably set to be, for example, about 0.04 less than that of the second surface acoustic wave resonator 502B, which is connected to the second IDT 505 in which the electrode finger adjacent to the IDT 504 is a signal electrode. The designs of the surface acoustic wave resonators 502A and 502B are basically identical except that the duty ratioes of electrode fingers of IDTs and reflectors are set to be different from one another.

In Fig. 35, the solid line is used to indicate the result of the degree of phase balance in the configuration of the tenth additional arrangement. For comparison, in Fig. 35, the broken line is used to indicate the result of the degree of phase balance in the third example of the related art, in which the duty ratioes of electrode fingers of the surface acoustic wave resonators 502A and 502B are set to be equal. In the tenth additional arrangement, the degree of phase balance is improved as compared to the third example of the related art.

When, as in the above preferred embodiments, surface acoustic wave resonators are respectively connected to the IDTs 503 and 503 and the duty ratioes of their electrode fingers are set to be different from one another, by decreasing the duty ratio of electrode fingers of a surface acoustic wave resonator connected to the IDT 503 in which the electrode finger adjacent to the IDT 504 having the bisected comb electrodes 516 and 517, as compared to the duty ratio of electrode fingers of a surface acoustic wave resonator connected to the IDT 505 in which the electrode finger adjacent to the IDT 504 is a signal electrode, the degree of balance between balanced signal terminals is improved. This does not depend at all on the polarities of electrode fingers adjacent to the IDTs 503 and 505.

In addition, in the tenth additional arrangement, all of the duty ratioes of the electrode fingers of the IDTs and reflectors of the surface acoustic wave resonators 502A and 502B are preferably set to be different from one another. However, the duty ratio of only a portion of the electrode fingers may be set to be different from one another.

Moreover, as shown in Fig. 31, surface acoustic wave resonators may be respectively connected to first and second comb electrodes, and the duty ratioes of electrode fingers of the surface acoustic wave resonators 1201 and 1202 may be set to be different from one another.

In this case by decreasing the duty ratio of electrode fingers of the surface acoustic wave resonator 1201 which is connected to the first comb electrode 516 closer to the first IDT 503 in which the electrode finger adjacent to the IDT 504 is a ground electrode, compared with the duty ratio of electrode fingers of the surface acoustic wave resonator 1202 which is connected to the second bisected comb electrode 517 closer to the second IDT 505 in which the electrode finger adjacent to the IDT 504 is a signal electrode, the degree of balance between balanced signal terminals is improved.

In addition, as shown in Fig. 32, the two-terminal-pair surface acoustic wave resonator 1301 may be used as the surface acoustic wave resonator, and the duty ratioes of electrode fingers of the IDTs 1302 and 1303 may be set to be different from one another. In this case, by decreasing the duty ratio of electrode fingers of the IDT 1302 which is connected to the first comb electrode 516 closer to the first IDT 503 in which the electrode finger adjacent to the IDT 504 is a ground electrode, compared with the duty ratio of electrode fingers of the IDT 1303 which is connected to the second bisected comb electrode 517 closer to the second IDT 505 in which the electrode finger adjacent to the IDT 504 is a signal electrode, the degree of balance between balanced signal terminals is improved.

In Fig. 32, a comb electrode of the IDT 504 which is not divided is a float electrode instead of the ground electrode described in the other preferred embodiments. However, even in this configuration, a similar advantage is obtained.

In addition, in the first and second preferred embodiments and in the first to tenth additional arrangements, between the results of the degree of amplitude balance and the degree of phase balance, the one which is improved is shown in the characteristic graphs. However, it has been confirmed that the degree of balance, in the other one in which no improvement is found, does not substantially change or deteriorate.

Features of the present invention described in the first and second preferred embodiments and in the first to tenth additional arrangements can be combined in any manner except where collateral use is impossible such as a case in which an outermost electrode finger of the central IDT is a ground electrode or float electrode and a case in which it is a signal electrode. A combination of these enables further enhancement of the advantages disclosed above.

A surface acoustic wave filter according to the first and second preferred embodiments and in the first to tenth additional arrangements has a balance-unbalance conversion function by setting a difference between the impedance of a balanced side and the impedance of an unbalanced side, and improves the degree of balance. Thus, by using the surfaced acoustic wave filter as a filter in a small communication apparatus, such a cellular phone, communication characteristics of the communication apparatus are improved. Accordingly, it is suitable for use in such a communication apparatus.

While the present invention has been described with respect to preferred embodiments, it will be apparent to those skilled in the art that the disclosed invention may be modified in numerous ways and may assume many embodiments other than those specifically set out and described above, within the scope of the appended claims.

## Claims

1. A surface acoustic wave filter comprising:
a piezoelectric substrate;
an unbalanced signal terminal (511);
first and second balanced signal terminals (512,513); and
a longitudinally-coupled-resonator surface acoustic wave filter portion (501) provided on the piezoelectric substrate and connected between the unbalanced signal terminal (511) and the first and second balanced signal terminals (512,513);
wherein:
the longitudinally-coupled-resonator surface acoustic wave filter portion (501) includes an odd number of at least three interdigital transducers (503-505) arranged such that a plurality of comb electrodes having a plurality of electrode fingers are interdigitated, the interdigital transducers (503-505) being disposed along a surface-acoustic-wave propagation direction, and first and second reflectors (506,507) disposed along the surface-acoustic-wave propagation direction so that the at least three interdigital transducers (503-505) are located between the first and second reflectors (506,507);
the odd number of at least three interdigital transducers include a central interdigital transducer (504) arranged in the approximate center, and first and second interdigital transducers (503,505) disposed at two sides of the central interdigital transducer (504), the outermost electrode fingers of the central interdigital transducer (504) being adjacent to the first and second interdigital transducers (503,505), the polarity of the first interdigital transducer (503) being inverted relative to the polarity of the second interdigital transducer (505);
one of the opposing comb electrodes of the central interdigital transducer (504) is bisected and so comprises first and second bisected comb electrodes(516,517);
the first and second bisected comb electrodes (516,517) are respectively arranged toward the first and second interdigital transducers (503,505) and are respectively connected to said first and second balanced signal terminals (512,513); and
the first and second interdigital transducers (503,505) which are adjacent to the central interdigital transducer are electrically connected to said unbalanced signal terminal (511);
**characterized in that:**
an electrode finger of the first interdigital transducer (503) which is adjacent to the central interdigital transducer (504) is a ground electrode, and an electrode finger of the second interdigital transducer (505) which is adjacent to the central interdigital transducer (504) is a signal electrode;
and either:
the polarities of two outermost electrode fingers of the central interdigital transducer (504) are substantially identical to that of one of the ground electrode and a float electrode, and the electrode finger pitch of at least a portion of the first interdigital transducer (503) is greater than the electrode finger pitch of the second interdigital transducer (505); or
the polarities of two outermost electrode fingers of the central interdigital transducer (504) are substantially identical to that of the signal electrode, and the electrode finger pitch of at least a portion of the second interdigital transducer (505) is greater than the electrode finger pitch of the first interdigital transducer (503).

2. The surface acoustic wave filter according to Claim 1, wherein the electrode finger pitch of at least a portion of the first bisected comb electrode (516), which is closer to the first interdigital transducer (503), is greater than the electrode finger pitch of the second bisected comb electrode (517).

3. The surface acoustic wave filter according to Claim 1, wherein the distance between the centers of the adjacent outermost electrode fingers of the first interdigital transducer (503) and the central interdigital transducer (504) is greater than the distance between the centers of the adjacent outermost electrode fingers of the second interdigital transducer (505) and the central interdigital transducer (504).

4. The surface acoustic wave filter according to Claim 1, wherein the polarities of two outermost electrode fingers of the central interdigital transducer (504) are substantially identical to that of a ground electrode or a float electrode, and the distance between the centers of the adjacent outermost electrode fingers of the first interdigital transducer (503) and the first reflector (506) is greater than the distance between the centers of the adjacent outermost electrode fingers of the second interdigital transducer (505) and the second reflector (507).

5. The surface acoustic wave filter according to Claim 1, wherein the polarities of two outermost electrode fingers of the central interdigital transducer (504) are substantially identical to that of a signal electrode, and the distance between the centers of the adjacent outermost electrode fingers of the second interdigital transducer (505) and the second reflector (507) is greater than the distance between the centers of the adjacent outermost electrode fingers of the first interdigital transducer (503) and the first reflector (506).

6. The surface acoustic wave filter according to Claim 1, wherein the duty ratio of electrode fingers in at least a portion of the first interdigital transducer (503) is greater than the duty ratio of electrode fingers of the second interdigital transducer (505).

7. The surface acoustic wave filter according to Claim 1, wherein the polarities of two outermost electrode fingers of the central interdigital transducer (504) are substantially identical to that of a ground electrode or a float electrode, and the duty ratio of electrode fingers of the first bisected comb electrode (516) is greater than the duty ratio of electrode fingers of the second bisected comb electrode (517).

8. The surface acoustic wave filter according to Claim 1, wherein two outermost electrode fingers of the central interdigital transducer (504) are signal electrodes, and the duty ratio of electrode fingers of the second bisected comb electrode (517) is greater than the duty ratio of electrode fingers of the first bisected comb electrode (516).

9. The surface acoustic wave filter according to Claim 1, wherein:
the odd number of at least three interdigital transducers (503-505) has, in areas in which two interdigital transducers are adjacent to each other, narrow pitch electrode finger portions (514,515) having smaller electrode finger pitches than the surrounding electrode finger portions; and
the electrode finger pitch of one narrow pitch electrode finger portion (514) in an area in which the first interdigital transducer (503) and the first bisected comb electrode (516) are adjacent to each other is greater than the electrode finger pitch of one narrow pitch electrode finger portion (515) in an area in which the second interdigital transducer (505) and the second bisected comb electrode (517) are adjacent to each other.

10. The surface acoustic wave filter according to any one of Claims 1 to 9, further comprising a second longitudinally-coupled-resonator surface acoustic wave filter portion (551) cascade-connected to said longitudinally-coupled-resonator surface acoustic wave filter portion (501).

11. A communication apparatus including the surface acoustic wave filter as defined in any one of Claims 1 to 10.

## Patentansprüche

1. Ein Oberflächenwellenfilter, das folgende Merkmale aufweist:
ein piezoelektrisches Substrat;
einen unsymmetrischen Signalanschluss (511);
einen ersten und einen zweiten symmetrischen Signalanschluss (512, 513); und
einen Längsgekoppelter-Resonator-Oberflächenwellenfilterabschnitt (501), der auf dem piezoelektrischen Substrat vorgesehen ist und zwischen den unsymmetrischen Signalanschluss (511) und den ersten und den zweiten symmetrischen Signalanschluss (512, 513) geschaltet ist;
wobei:
der Längsgekoppelter-Resonator-Oberflächenwellenfilterabschnitt (501) eine ungerade Anzahl von zumindest drei Interdigitalwandlern (503-505) umfasst, die derart angeordnet sind, dass eine Mehrzahl von Kammelektroden, die eine Mehrzahl von Elektrodenfingern aufweisen, ineinander greifen, wobei die Interdigitalwandler (503-505) entlang einer Oberflächenwellenausbreitungsrichtung angeordnet sind und ein erster und ein zweiter Reflektor (506, 507) entlang der Oberflächenwellenausbreitungsrichtung angeordnet sind, so dass sich die zumindest drei Interdigitalwandler (503-505) zwischen dem ersten und dem zweiten Reflektor (506, 507) befinden;
die ungerade Anzahl von zumindest drei Interdigitalwandlern einen mittleren Interdigitalwandler (504), der in der ungefähren Mitte angeordnet ist, und einen ersten und einen zweiten Interdigitalwandler (503, 505), die an zwei Seiten des mittleren Interdigitalwandlers (504) angeordnet sind, umfassen, wobei die äußersten Elektrodenfinger des mittleren Interdigitalwandlers (504) zu dem ersten und dem zweiten Interdigitalwandler (503, 505) benachbart sind, wobei die Polarität des ersten Interdigitalwandlers (503) relative zu der Polarität des zweiten Interdigitalwandlers (505) invertiert ist;
eine der gegenüberliegenden Kammelektroden des mittleren Interdigitalwandlers (504) halbiert ist und somit eine erste und eine zweite halbierte Kammelektrode (516, 517) aufweist;
die erste und die zweite halbierte Kammelektrode (516, 517) hin zu dem ersten beziehungsweise dem zweiten Interdigitalwandler (503, 505) angeordnet sind und mit dem ersten beziehungsweise dem zweiten symmetrischen Signalanschluss (512, 513) verbunden sind; und
der erste und der zweite Interdigitalwandler (503, 505), die zu dem mittleren Interdigitalwandler benachbart sind, mit dem unsymmetrischen Signalanschluss (511) elektrisch verbunden sind;
**dadurch gekennzeichnet, dass**
ein Elektrodenfinger des ersten Interdigitalwandlers (503), der zu dem mittleren Interdigitalwandler (504) benachbart ist, eine Masseelektrode ist und ein Elektrodenfinger des zweiten Interdigitalwandlers (505), der zu dem mittleren Interdigitalwandler (504) benachbart ist, eine Signalelektrode ist;
und entweder:
die Polaritäten von zwei äußersten Elektrodenfingern des mittleren Interdigitalwandlers (504) mit der Polarität entweder der Masseelektrode oder einer Schwebeelektrode im Wesentlichen identisch sind und der Elektrodenfingerabstand zumindest eines Abschnitts des ersten Interdigitalwandlers (503) größer ist als der Elektrodenfingerabstand des zweiten Interdigitalwandlers (505); oder
die Polaritäten von zwei äußersten Elektrodenfingern des mittleren Interdigitalwandlers (504) mit der Polarität der Signalelektrode im Wesentlichen identisch sind und der Elektrodenfingerabstand zumindest eines Abschnitts des zweiten Interdigitalwandlers (505) größer ist als der Elektrodenfingerabstand des ersten Interdigitalwandlers (503).

2. Das Oberflächenwellenfilter gemäß Anspruch 1, bei dem der Elektrodenfingerabstand zumindest eines Abschnitts der ersten halbierten Kammelektrode (516), der sich näher an dem ersten Interdigitalwandler (503) befindet, größer ist als der Elektrodenfingerabstand der zweiten halbierten Kammelektrode (517).

3. Das Oberflächenwellenfilter gemäß Anspruch 1, bei dem die Entfernung zwischen der jeweiligen Mitte der benachbarten äußersten Elektrodenfinger des ersten Interdigitalwandlers (503) und des mittleren Interdigitalwandlers (504) größer ist als die Entfernung zwischen der jeweiligen Mitte der benachbarten äußerten Elektrodenfinger des zweiten Interdigitalwandlers (505) und des mittleren Interdigitalwandlers (504).

4. Das Oberflächenwellenfilter gemäß Anspruch 1, bei dem die Polaritäten von zwei äußersten Elektrodenfingern des mittleren Interdigitalwandlers (504) mit der Polarität einer Masseelektrode oder einer Schwebeelektrode im Wesentlichen identisch sind und die Entfernung zwischen der jeweiligen Mitte der benachbarten äußersten Elektrodenfinger des ersten Interdigitalwandlers (503) und des ersten Reflektors (506) größer ist als die Entfernung zwischen der jeweiligen Mitte der benachbarten äußersten Elektrodenfinger des zweiten Interdigitalwandlers (505) und des zweiten Reflektors (507).

5. Das Oberflächenwellenfilter gemäß Anspruch 1, bei dem die Polaritäten von zwei äußersten Elektrodenfingern des mittleren Interdigitalwandlers (504) mit der Polarität einer Signalelektrode im Wesentlichen identisch sind und die Entfernung zwischen der jeweiligen Mitte der benachbarten äußersten Elektrodenfinger des zweiten Interdigitalwandlers (505) und des zweiten Reflektors (507) größer ist als die Entfernung zwischen der jeweiligen Mitte der benachbarten äußersten Elektrodenfinger des ersten Interdigitalwandlers (503) und des ersten Reflektors (506).

6. Das Oberflächenwellenfilter gemäß Anspruch 1, bei dem das Lastverhältnis von Elektrodenfingern in zumindest einem Abschnitt des ersten Interdigitalwandlers (503) größer ist als das Lastverhältnis von Elektrodenfingern des zweiten Interdigitalwandlers (505).

7. Das Oberflächenwellenfilter gemäß Anspruch 1, bei dem die Polaritäten von zwei äußersten Elektrodenfingern des mittleren Interdigitalwandlers (504) mit der Polarität einer Masseelektrode oder einer Schwebeelektrode im Wesentlichen identisch sind und das Lastverhältnis von Elektrodenfingern der ersten halbierten Kammelektrode (516) größer ist als das Lastverhältnis von Elektrodenfingern der zweiten halbierten Kammelektrode (517).

8. Das Oberflächenwellenfilter gemäß Anspruch 1, bei dem zwei äußerste Elektrodenfinger des mittleren Interdigitalwandlers (504) Signalelektroden sind und das Lastverhältnis von Elektrodenfingern der zweiten halbierten Kammelektrode (517) größer ist als das Lastverhältnis von Elektrodenfingern der ersten halbierten Kammelektrode (516).

9. Das Oberflächenwellenfilter gemäß Anspruch 1, bei dem:
die ungerade Anzahl von zumindest drei Interdigitalwandlern (503-505) in Bereichen, in denen zwei Interdigitalwandler zueinander benachbart sind, Elektrodenfingerabschnitte (514, 515) mit schmalem Abstand umfassen, die geringere Elektrodenfingerabstände aufweisen als die umgebenden Elektrodenfingerabschnitte; und
der Elektrodenfingerabstand eines Elektrodenfingerabschnitts mit schmalem Abstand (514) in einem Bereich, in dem der erste Interdigitalwandler (503) und die erste halbierte Kammelektrode (516) zueinander benachbart sind, größer ist als der Elektrodenfingerabstand eines Elektrodenfingerabschnitts mit schmalem Abstand (515) in einem Bereich, in dem der zweite Interdigitalwandler (505) und die zweite halbierte Kammelektrode (517) zueinander benachbart sind.

10. Das Oberflächenwellenfilter gemäß einem der Ansprüche 1 bis 9, das ferner einen zweiten Längsgekoppelter-Resonator-Oberflächenwellenfilterabschnitt (551) aufweist, der mit dem Längsgekoppelter-Resonator-Oberflächenwellenfilterabschnitt (501) in Kaskade geschaltet ist.

11. Eine Kommunikationsvorrichtung, die das Oberflächenwellenfilter gemäß der Definition in einem der Ansprüche 1 bis 10 umfasst.

## Revendications

1. Filtre à ondes acoustiques de surface, comprenant :
un substrat piézoélectrique ;
une borne pour signaux asymétriques (511);
une première et une deuxième bornes pour signaux symétriques (512, 513) ; et
une partie de filtre à ondes acoustiques de surface (501) de type résonateur à couplage longitudinal, prévue sur le substrat piézoélectrique et connectée entre la borne pour signaux asymétriques (511) et les première et deuxième bornes pour signaux symétriques (512, 513) ;
dans lequel :
la partie de filtre à ondes acoustiques de surface (501) de type résonateur à couplage longitudinal comprend un nombre impair d'au moins trois transducteurs interdigitaux (503-505) disposés de telle sorte que plusieurs électrodes en peigne ayant une pluralité de doigts-électrodes soient interdigitées, les transducteurs interdigitaux (503-505) étant disposés le long d'une direction de propagation des ondes acoustiques de surface, et des premier et deuxième réflecteurs (506, 507) disposés le long de la direction de propagation des ondes acoustiques de surface de telle sorte que les au moins trois transducteurs interdigitaux (503-505) soient situés entre les premier et deuxième réflecteurs (506, 507);
le nombre impair d'au moins trois transducteurs interdigitaux comprend un transducteur interdigital central (504) disposé approximativement au centre, et des premier et deuxième transducteurs interdigitaux (503, 505) disposés de chaque côté du transducteur interdigital central (504), les doigts-électrodes les plus à l'extérieur du transducteur interdigital central (504) étant respectivement contigus aux premier et deuxième transducteurs interdigitaux (503, 505), la polarité du premier transducteur interdigital (503) étant inversée par rapport à la polarité du deuxième transducteur interdigital (505) ;
l'une des électrodes en peigne opposées du transducteur interdigital central (504) est divisée en deux parties et comprend ainsi une première et une deuxième électrodes en peigne fractionnées (516, 517);
les première et deuxième électrodes en peigne fractionnées (516, 517) sont respectivement disposées vers les premier et deuxième transducteurs interdigitaux (503, 505) et sont respectivement connectées auxdites première et deuxième bornes pour signaux symétriques (512, 513); et
les premier et deuxième transducteurs interdigitaux (503, 505) qui sont contigus au transducteur interdigital central sont connectés électriquement à ladite borne pour signaux asymétriques (511);
**caractérisé en ce que :**
un doigt-électrode du premier transducteur interdigital (503) qui est contigu au transducteur interdigital central (504) est une électrode de masse, et un doigt-électrode du deuxième transducteur interdigital (505) qui est contigu au transducteur interdigital central (504) est une électrode de signal ;
et
soit les polarités des deux doigts-électrodes les plus à l'extérieur du transducteur interdigital central (504) sont essentiellement identiques à celle de l'électrode de terre ou d'une électrode flottante, et le pas entre les doigts-électrodes d'au moins une partie du premier transducteur interdigital (503) est plus grand que le pas entre les doigts-électrodes du deuxième transducteur interdigital (505) ;
soit les polarités des deux doigts-électrodes les plus à l'extérieur du transducteur interdigital central (504) sont essentiellement identiques à celle de l'électrode de signal, et le pas entre les doigts-électrodes d'au moins une partie du deuxième transducteur interdigital (505) est plus grand que le pas entre les doigts-électrodes du premier transducteur interdigital (503).

2. Filtre à ondes acoustiques de surface selon la revendication 1, dans lequel le pas entre les doigts-électrodes d'au moins une partie de la première électrode en peigne fractionnée (516), qui est la plus proche du premier transducteur interdigital (503), est plus grand que le pas entre les doigts-électrodes de la deuxième électrode en peigne fractionnée (517).

3. Filtre à ondes acoustiques de surface selon la revendication 1, dans lequel la distance entre les centres des doigts-électrodes les plus à l'extérieur contigus du premier transducteur interdigital (503) et du transducteur interdigital central (504) est plus grande que la distance entre les centres des doigts-électrodes les plus à l'extérieur contigus du deuxième transducteur interdigital (505) et du transducteur interdigital central (504).

4. Filtre à ondes acoustiques de surface selon la revendication 1, dans lequel les polarités des deux doigts-électrodes les plus à l'extérieur du transducteur interdigital central (504) sont essentiellement identiques à celle d'une électrode de masse ou d'une électrode flottante, et la distance entre les centres des doigts-électrodes les plus à l'extérieur contigus du premier transducteur interdigital (503) et du premier réflecteur (506) est plus grande que la distance entre les centres des doigts-électrodes les plus à l'extérieur contigus du deuxième transducteur interdigital (505) et du deuxième réflecteur (507).

5. Filtre à ondes acoustiques de surface selon la revendication 1, dans lequel les polarités des deux doigts-électrodes les plus à l'extérieur du transducteur interdigital central (504) sont essentiellement identiques à celle d'une électrode de signal, et la distance entre les centres des doigts-électrodes les plus à l'extérieur contigus du deuxième transducteur interdigital (505) et du deuxième réflecteur (507) est plus grande que la distance entre les centres des doigts-électrodes les plus à l'extérieur contigus du premier transducteur interdigital (503) et du premier réflecteur (506).

6. Filtre à ondes acoustiques de surface selon la revendication 1, dans lequel le facteur de marche des doigts-électrodes dans au moins une partie du premier transducteur interdigital (503) est supérieur au facteur de marche des doigts-électrodes du deuxième transducteur interdigital (505).

7. Filtre à ondes acoustiques de surface selon la revendication 1, dans lequel les polarités des deux doigts-électrodes les plus à l'extérieur du transducteur interdigital central (504) sont essentiellement identiques à celle d'une électrode de masse ou d'une électrode flottante, et le facteur de marche des doigts-électrodes de la première électrode en peigne fractionnée (516) est supérieur au facteur de marche des doigts-électrodes de la deuxième électrode en peigne fractionnée (517).

8. Filtre à ondes acoustiques de surface selon la revendication 1, dans lequel deux doigts-électrodes les plus à l'extérieur du transducteur interdigital central (504) sont des électrodes de signal, et le facteur de marche des doigts-électrodes de la deuxième électrode en peigne fractionnée (517) est supérieur au facteur de marche des doigts-électrodes de la première électrode en peigne fractionnée (516).

9. Filtre à ondes acoustiques de surface selon la revendication 1,
dans lequel :
le nombre impair d'au moins trois transducteurs interdigitaux (503-505) a, dans les régions dans lesquelles deux transducteurs interdigitaux sont contigus l'un à l'autre, des parties de doigts-électrodes à pas étroit (514, 515) ayant des pas entre les doigts-électrodes plus petits que ceux des parties de doigts-électrodes voisines ; et
le pas entre les doigts-électrodes d'une partie de doigts-électrodes à pas étroit (514) dans une région dans laquelle le premier transducteur interdigital (503) et la première électrode en peigne fractionnée (516) sont contigus l'un à l'autre est plus grand que le pas entre les doigts-électrodes d'une partie de doigts-électrodes à pas étroit (515) dans une région dans laquelle le deuxième transducteur interdigital (505) et la deuxième électrode en peigne fractionnée (517) sont contigus l'un à l'autre.

10. Filtre à ondes acoustiques de surface selon l'une quelconque des revendications 1 à 9, comprenant en outre une deuxième partie de filtre à ondes acoustiques de surface (551) de type résonateur à couplage longitudinal, connectée en cascade à ladite première partie de filtre à ondes acoustiques de surface (501) de type résonateur à couplage longitudinal.

11. Appareil de communication comprenant le filtre à ondes acoustiques de surface tel que défini dans l'une quelconque des revendications 1 à 10.
